# EUROPEAN PATENT SPECIFICATION

(11) **EP 3 695 026 B1**
(45) Date of publication and mention of the grant of the patent: **21.01.2026**
(21) Application number: 18735132.5
(22) Date of filing: 11.06.2018
(51) Int. Cl.: C23C 16/16, C23C 16/34, C23C 16/448, C23C 16/455, C23C 16/52

(54) **METHOD AND SYSTEM FOR THE INTEGRATED SYNTHESIS, DELIVERY, AND PROCESSING OF SOURCE CHEMICALS FOR THIN FILM MANUFACTURING**
VERFAHREN UND SYSTEM ZUR INTEGRIERTEN SYNTHESE, LIEFERUNG UND VERARBEITUNG VON AUSGANGSCHEMIKALIEN FÜR DIE HERSTELLUNG VON DÜNNSCHICHTEN
PROCÉDÉ ET SYSTÈME POUR LA SYNTHÈSE, LA DISTRIBUTION ET LE TRAITEMENT INTÉGRÉS DE PRODUITS CHIMIQUES SOURCES POUR LA FABRICATION DE FILM MINCE

(30) Priority: 12.10.2017 US 201762571439 P
(43) Date of publication of application: 19.08.2020
(73) Proprietor: Gelest, Inc., Morrisville, PA 19067 (US)
(72) Inventor: ARKLES, Barry, C., Pipersville PA 18947 (US); KALOYEROS, Alain, E., Slingerlands NY 12159 (US); ROBERTSON, Eric, Anthony, Easton PA 18042 (US)
(74) Representative: LBP Lemcke, Brommer & Partner Patentanwälte mbB
(86) International application number: PCT/US2018/036855
(87) International publication number: WO 2019/074553

(56) References cited:
- EP-A1- 2 166 129
- WO-A1-00/26432
- WO-A2-2008/067537
- AU-B1- 2005 234 712
- CA-A1- 2 379 491
- JP-A- H05 287 535
- US-A- 4 044 144
- US-A1- 2006 165 892
- US-A1- 2010 062 181
- US-A1- 2010 129 548
- US-A1- 2011 136 347
- "Optical studies of very high-purity GaAs grown by metal-organic chemical-vapor deposition using a point-of-use arsine (AsH3) generator", APPLIED PHYSICS LETTERS, A I P PUBLISHING LLC, US, vol. 71, no. 6, 11 August 1997 (1997-08-11), pages 791, XP012019549, ISSN: 0003-6951, DOI: 10.1063/1.119647

## Description

### BACKGROUND OF THE INVENTION

This invention involves methods and an integrated system for the synthesis, transport and delivery, and processing of source chemicals for thin film manufacturing, including, for example, deposition, etching, and patterning.

Across multiple industries including integrated circuit (IC) devices and microelectro-mechanical systems (MEMS), conventional thin film manufacturing methodologies, including but not limited to chemical vapor deposition (CVD), atomic layer deposition (ALD), liquid-phase plating, etching (including atomic layer etching, partial, and complete material removal processes), implantation (such as ion implantation), and patterning (i.e., forming a pre-defined structure into an already deposited layer, such as transistor patterns onto a silicon substrate), primarily involve a five step approach, as follows: (1) the precursors are manufactured or synthesized at a first location, such as a chemical manufacturing plant; (2) the precursors are then stored in leakage and spill-proof customized vessels or tailored storage facilities until they are ready to be shipped to a customer; (3) the precursors are then transported in the leakage and spill-proof customized vessels or tailored storage facilities by land, air, or sea to a second location, typically the customer's industrial plant, where they are intended to be used in the production of a device or system; (4) the precursors remain stored in the leakage and spill-proof customized vessels or tailored storage facilities at the second location, until they are ready to be used; (5) finally, the precursors are introduced into the manufacturing process being carried out at the second location, so that they may be applied or consumed in the growth, construction, or formation of a thin film as part of a device or system fabrication technology.

However, the conventional manufacturing methodologies discussed above suffer from a variety of technological, safety, environmental, and economic inefficiencies and shortcomings. Conventional manufacturing methodologies are inhibited by their inability to transport chemicals that, for example, have dangerous inhalation toxicity and/or are unstable due to shock-sensitivity, by the hazards of bulk storage or that require significant cooling to retain their integrity prior to being used. Another major shortcoming is the unnecessarily protracted time windows and lengthy durations that elapse between the synthesis of the precursors and the actual usage of the precursors. This shortcoming results in significant financial burden, due to the capital expenses associated with the need to stock and store expensive precursors at the chemical synthesis facility, prior to the precursors being sold and shipped to the customer facility for use. Present protocols also require the use of specialized containers to preserve the integrity of the precursors until they are used, which is another added cost. Redundancies are inherent in storage and transportation both at the precursor synthesis and consumption facilities. The dual handling, storage, treatment, and disposal of byproducts from precursor synthesis at the precursor synthesis facility and precursor consumption at the customer facility generate significant further costs. In addition, concerns about the change of product quality with time can create additional costs to assure the product has not drifted out of target technical specification from the time of manufacture to the time of consumption.

Equally important are the environmental, safety, and health dangers involved with the transportation of the chemicals by air, sea, or land, and the resulting devastating impact on humans and the environment that could stem from spillage of the chemicals, for example due to human error, quality control failure, and/or other unforeseen accidents that may occur during the shipping and handling phases.

These drawbacks and shortcomings are exemplified in the semiconductor (i.e., computer chip) and hetero-device integrated circuitry (IC) industry, where many of these conventional manufacturing methodologies are employed in what is commonly referred to as batch, stand-alone, and cluster tool manufacturing or processing equipment. Batch tool processing involves the application of a manufacturing technique to multiple wafers concurrently in a single manufacturing apparatus. In contrast, stand-alone tool processing involves the application of a manufacturing technique to a single wafer in an individual piece of equipment, prior to transporting the wafer to a different batch, stand-alone, or cluster tool manufacturing equipment. Cluster tool processing, on the other hand, involves several single-wafer processing chambers and a wafer-handling robot.

Cluster tool processing has been increasingly used in recent years for diverse wafer fabrication processes, as described in an article by A. Bowling entitled "Single-Wafer Processing And Real-Time Process Control For Semiconductor Integrated Circuit Manufacturing," published in International Symposium on Semiconductor Manufacturing (A. Bowling, Int'l. Symposium on Semiconductor Mfg., (June 21-22, 1994, IEEE)). The introduction of the single-wafer cluster tool in the mid-1980s by Applied Materials was the last time a significant new manufacturing equipment methodology was successfully introduced into the IC industry. The replacement of the majority of batch processing protocols prevailing at the time with cluster tool based manufacturing enabled the IC industry to: reduce total factory cost; embed computer-controlled sensors into the manufacturing equipment to provide real-time diagnosis; achieve multiplicity in the concurrent implementation of different manufacturing recipes; ensure rapid manufacturing cycle times; implement short-loop manufacturing cycles to test material and process innovations; and realize flexibility in the simultaneous fabrication of various IC products. These achievements are described, for example, at Applied Materials' website, and in articles by M.M. Moslehi et al. and S.M. George et al. (M.M. Moslehi et al., "Single-Wafer Integrated Semiconductor Device Processing," IEEE Transactions on Electron Devices, V. 39, pp. 4-31 (1992); S.M. George, "Atomic Layer Deposition: An Overview," Chem. Rev., V. 110, pp. 111-131 (2010)).

The acceptance of cluster tool manufacturing methodology has been predicated on the requirement for sequential processes, such as CVD and ALD processes that require strict control of processing parameters, including exposure time, pressure, temperature, and other parameters. For example, cluster tools are typically formed at multiple wafer processing stations placed around a central, automated handling unit with fixed inputs of precursors which are supplied to each processing station, such as a deposition chamber. The inputs are typically stable reservoirs of gases or volatile materials. A wafer processed in a first deposition chamber then leaves the first deposition chamber within a specified time limit and moves, typically under *in-situ,* high vacuum conditions, to another deposition chamber within the cluster tool without a vacuum break.

Without the *in-situ,* high vacuum conditions, the device structures being built on the wafer would be subject to quality problems due to residual precursor gas and by-products, heat within the initial deposition chamber, cross-contamination issues with other deposition precursors or precursor by-products, oxidation and inclusion of external contaminants if the wafers were exposed to air while being transported from one chamber to the next, and the like. The *in-situ* transfer between the processing stations under vacuum enables tight management of atmosphere or environment to ensure control, and practically eliminates contamination between process steps.

The generation and supply of the precursors, however, is independent of the cluster tool. Accordingly, the high level of automation and control utilized in the cluster tool does not extend to the generation of the precursor itself, but rather only to the controlled delivery or supply of the precursor to the deposition chambers. Further, this modality intrinsically depends on maintaining the thermal stability and chemical integrity of the precursors under storage conditions until the time of use.

In addition, the well-established drive toward more complex and smaller semiconductor and hetero-device structures is causing increased limitations in established thin film deposition methodologies. Specifically, low thermal exposure during fabrication of the device structures is becoming essential due to the complexity and thermally-fragile nature of the device structures, where temperature changes can induce undesirable reactions within substructures. This danger is described, for example, in an article by M. Badaroglu (M. Badaroglu, ITRS Summer Conference, Roadmap Meeting, Stanford University, July 11-12, 2015; and International Technology Roadmap for Semiconductors 2.0, 2015 Edition, Interconnect). Furthermore, with the thickness of films approaching atomic dimensions, thermally-induced migration, in addition to electromigration, can alter film properties and performance.

Another consideration is the desire to move towards more flexible substrates, such as plastic or polymer substrates, which typically cannot withstand the same process temperatures as traditional substrates, such as silicon or gallium nitride. *See, e.g.,* S. Majee et al., "Permeation barrier performance of Hot Wire-CVD grown silicon-nitride films treated by argon plasma," Thin Solid Films, V. 575, pp. 72-75 (2015).

Yet another consequence of the push towards more complex and smaller fabricated structures is the drive to integrate new material and process technologies. While semiconductors in the 1990s utilized a maximum of approximately twelve atomic elements, the International Technology Roadmap for Semiconductors anticipates nearly fifty atomic elements were used in manufacturing semiconductors in 2015. *See, e.g.,* B. Bottoms et al., ITRS Summer Conference, Roadmap Meeting, Stanford University, July 11-12, 2015; R. Allen et al., ITRS Summer Conference, Roadmap Meeting, Stanford University, July 11-12, 2015; S. Das, ITRS Architecture Workshop, February 26-27, 2015. When compounds resulting from possible combinations of these different atomic elements are considered, the growth in material (e.g., metal, semiconductor, insulator, dielectric, and the like) diversity and complexity is expanding at a nearly exponential pace. However, this growth is severely limited by the inability to develop storage stable and transportable sources of volatile precursors that can react controllably and reliably within the processing stations of the manufacturing equipment to form high quality films.

A further consequence of the drive towards more complex and smaller fabricated structures is the increasing costs associated with the manufacturing of such structures, due to their complexity, incorporation of new materials and process technologies, and the need for extreme precision and tight control in the formation of ultrathin films (e.g., as thin as an atomic layer).

Accordingly, a method and system for the synthesis, delivery, and processing of precursors for thin film manufacturing which eliminate redundant steps or reduce the number of steps in the manufacturing process, and thus lower the manufacturing cost for both conventional and new materials and processes, would be desirable. Further, a method that eliminates issues of precursor thermal and chemical stability would expand the ability to deposit new desirable thin film compositions that are currently unattainable by conventional methods and systems. Moreover, such a method and system would be highly desirable in multiple industrial sectors, including the semiconductor (e.g., computer chip), aircraft, energy, sensor, medical, biological, chemical, and defense industrial sectors.

### BRIEF SUMMARY OF THE INVENTION

The present invention relates to an integrated system for synthesis of a film-forming precursor, consumption of the precursor and formation of a thin film on a substrate, wherein the rate of precursor synthesis is synchronized with the rate of precursor consumption for formation of the thin film as disclosed in claims 1-30.

The present invention further relates to an integrated method for synthesis of a film-forming precursor, consumption of the precursor and formation of a thin film on a substrate as disclosed in claims 31-38.

The novel integration of thin film formation demand requirements with the generation and consumption of precursors, according to the present invention, enables practical deposition of thin compositions under conditions hitherto considered impractical for full-scale manufacturing. For example, in the cases of extremely toxic or potentially explosive precursors, it is possible to control the physical presence of the precursor below toxicity or self-accelerating decomposition hazard limits, and allow them to be immediately consumed in the manufacturing process. Also, because the first and second chambers are connected together and in communication with each other using strictly controlled valving and pumping systems, the integrity of each chamber's interior atmosphere is preserved and isolated, while precise flows of gases, chemicals, and precursors between the chambers is still enabled.

The novel integration of thin film formation demand requirements with the generation and consumption of precursors, according to the present invention, also permits the use of chemicals and precursors that are too unstable at room temperature or ones that require significant cooling to retain their integrity prior to being used. The present invention also enables the formation or volatilization of new and unconventional precursors and chemicals that are not yet on the market and are not currently used in manufacturing. The present invention also enables the formation or volatilization of known and desirable precursors and chemicals that heretofore were considered too toxic, too unstable or otherwise hazardous to be utilized in commercial thin film fabrication and modification processes.

The present invention also eliminates unnecessary steps in the conventional manufacturing processes, which require synthesizing precursors or chemicals in a first location, most commonly a chemical manufacturing plant, then transporting the precursors to a device or system manufacturing plant in a second location where they are consumed in a manufacturing process. More particularly, the present invention eliminates the step of transporting the synthesized precursors to the device or system manufacturing plant. In turn, the present invention also eliminates the need for costly specialized containers to preserve the integrity of the chemicals until they are used; eliminates the inherent redundancies in storage and transportation both at the chemical synthesis and customer facilities; and consolidates the dual handling, storage, treatment, and disposal of by-products from precursor synthesis at the chemical plant and precursor chemical consumption at the manufacturing plant into a single by-product disposal step at the manufacturing plant.

The present invention is also distinct from the concept of point-of-use generation of precursors. Generally speaking, there are two classes of point-of-use precursor generation. One class involves the formation of the precursor *in-situ* in the same chamber where thin film fabrication takes place, usually in the vapor space above the substrate. This class may be designated as *"in-situ* point-of-use precursor generation." The second class involves the generation of the precursor in a vessel in close proximity to the thin film processing or fabrication chamber, with the precursor either delivered immediately to the fabrication chamber or sequestered/stored until use at a later time. This class may be designated as *"ex-situ"* or "in proximity" point-of-use precursor generation.

Both *in-situ and ex-situ* point-of-use precursor generation have a number of inherent limitations and disadvantages. Examples of *in-situ* precursor generation are disclosed in U.S. Patent No. 6,730,367, U.S. Patent No. 5,478,435 and EP2166129. One inherent limitation of *in-situ* precursor generation is that the chemical reactions associated with precursor synthesis often interfere with chemical reactions associated with thin film fabrication. Also, precise management of processing conditions is difficult to achieve in *in situ* point-of-use precursor generation, due to intrinsic characteristics of the chemical reaction to synthesize the precursor, which could include the presence of starting materials, the production of byproducts and heat or light from the reaction of the multiple base chemical components required to synthesize the precursor. Such side effects of the reaction to synthesize the precursor could directly affect film formation and negatively impact the processing chamber, including resulting in adverse effects on chamber walls and substrate operating parameters, such as undesirable and uncontrollable increase in reactor wall and/or substrate temperature, and thermal- or light-induced damage to fragile substrates, such as plastics and polymers. The present invention provides a much more reliable and highly reproducible approach, since the base chemical components are injected into a separate synthesis chamber from that where the actual chemical reaction occurs, and only the resulting precursor is introduced into the processing reactor.

Another limitation of *in situ* point-of-use generation of precursors is the sequential nature of the synthesis and processing steps involved. In a first step, the processing chamber must be set to certain precursor synthesis parameters, in order to enable the multiple base components to react in close proximity to or inside the chamber to form the source precursor. Next, the processing chamber is purged to remove all synthesis byproducts, and finally the processing chamber is set to the actual substrate processing parameters (including substrate introduction) to enable precursor decomposition and film formation. However, this approach causes undesirable delays in wafer throughput (and therefore drives manufacturing costs higher), due to the successive steps of precursor formation under a first set of parameters in the processing chamber, then waiting to change those parameters to enable decomposition and film formation.

The present invention resolves these issues by continuously synthesizing the source precursor in a separate synthesis chamber, and constantly feeding the source precursor controllably and reliably into the processing chamber that has been preset to the desirable processing parameters where it is concurrently consumed in the fabrication or deposition process.

Further limitations of *in-situ* point-of-use generation of precursors are the challenges associated with precursor synthesis byproducts without contamination of the processing chamber and substrate. The present invention resolves these issues by, when necessary, removing precursor synthesis byproducts from the precursor synthesis chamber, prior to the introduction of the precursor into the processing chamber.

Yet another limitation of *in-situ* point-of-use generation of precursors is the concern that the base chemical components for synthesis of the precursor and the byproducts of such synthesis could be harmful or damaging to the processing chamber, as they could cause undesirable etching, corrosion, or oxidation of the fabrication chamber. The present invention resolves these issues by synthesizing the source precursor in a separate synthesis chamber that is specifically designed and built to handle corrosive, oxidizing, or otherwise interfering base chemical and reaction by-products, and by removing the precursor synthesis byproducts prior to the introduction of the precursor into the processing chamber.

A further limitation of *in-situ* point-of-use generation of precursors is that precursor synthesis is not interlocked with precursor consumption in the manufacturing process, which limits the ability to accurately control the manufacturing process to yield the precise deposition outcome, such as thin films of exact thickness and composition. The precise interlock of precursor generation and deposition process by an instrumental feedback loop is an important aspect of the present invention, as described in detail herein.

Examples of *ex-situ* or in-proximity point-of-use precursor generation are disclosed in J. P. ven der Ziel, Applied Physics Letters, Vol. 71:6, pp. 791-793 (1997); D.N. Buckley et al., Applied Physics Letters, Vol. 57:16, pp. 1684-1686 (1990); U.S. Patent No. 5,158,656; and U.S. Patent Application Publication No. 2011/0136347. A major limitation of the *ex-situ* point-of-use generation of precursors is that precursor synthesis is not tightly coupled to or synchronized with precursor consumption in the manufacturing process, which severely limits the ability to accurately control the manufacturing process to yield the precise deposition outcome, such as thin films of exact thickness, desired morphology, physical and chemical properties, and composition. For the ever-increasing importance of control in emerging manufacturing processes, see, e.g., A. Emami-Naeini et al., Proceedings of the Symposium to honor W. Wolovich, the 47th IEEE Conference on Decision and Control, Cancun, Mexico (December 9-11, 2008). The precise linking of precursor generation and deposition process by an instrumental feedback loop is an important aspect of the present invention, as described in detail herein.

The instrumental feedback loop may comprise *in-situ* and *ex-situ* monitoring and detection techniques, spectroscopies, and spectrometries to simultaneously monitor, concurrently control, and contemporarily manage and pair the various parameters of the precursor synthesis process and film manufacturing process. Such parameters may include, but are not limited to, temperature, pressure, flow rates of the raw materials and the precursor, and all operating conditions of the chemical synthesis generation itself, as well as the thin film manufacturing process. The *in-situ* and *ex-situ* detection techniques, spectroscopies, and spectrometries also enable end-point, real-time, in-situ monitoring and detection. These facilities also enable interaction between, coupling of and a closed feedback loop between the precursor synthesis parameters, the thin film processing parameters, and the reaction byproducts and effluents parameters.

Another limitation of the *ex-situ* or in-proximity point-of-use precursor generation is its failure to provide the key feedback elements and information necessary to ensure that precursor generation and delivery is occurring in a fashion that ensures the success of the thin film manufacturing process at achieving the desired thin film target. Conventional *ex-situ* or in-proximity point-of-use precursor generation focuses only on assessing the properties and characteristics of the precursor, such as quality (purity) and flow (amount being delivered to the manufacturing chamber). In contrast, the present invention enables highly desirable feedback, as determined by specific film properties measured in real time on the substrate. For example, *in-situ* sheet resistance and/or thickness measurements could be compiled while the manufacturing process is taking place to provide real time feedback for precursor generation and delivery.

### BRIEF DESCRIPTION OF THE SEVERAL VIEWS OF THE DRAWINGS

The following detailed description of preferred embodiments of the present invention will be better understood when read in conjunction with the appended drawings. For the purposes of illustrating the invention, there are shown in the drawings embodiments that are presently preferred. It is understood, however, that the invention is not limited to the precise arrangements and instrumentalities shown. In the drawings:
Fig. 1 is a schematic drawing of a precursor synthesis chamber connected to a thin-film processing chamber, in accordance with an embodiment of the present invention;
Fig. 2 is a schematic diagram of a system comprising a precursor synthesis chamber supplying a gas-phase precursor to a thin-film processing chamber via a manifold system, in accordance with an embodiment of the present invention;
Fig. 3 is a schematic diagram of a system comprising a precursor synthesis chamber supplying a liquid-phase precursor to a thin-film processing chamber via a manifold system, in accordance with an embodiment of the present invention;
Fig. 4 is a schematic depiction of a system comprising a plurality of precursor synthesis chambers connected to a single thin-film manufacturing unit, in accordance with an embodiment of the present invention;
Fig. 5 is a schematic depiction of a system comprising a plurality of precursor synthesis chambers in fluid communication with a plurality of thin-film processing chambers, in accordance with an embodiment of the present invention;
Fig. 6 is a schematic diagram of a cluster tool comprising a plurality of integrated precursor synthesis chambers and thin-film processing chambers, in accordance with an embodiment of the present invention; and
Fig. 7 is a schematic process drawing of a manufacturing technique involving a flexible substrate in the form of a continuous roll or coil, in accordance with an embodiment of the present invention.

### DETAILED DESCRIPTION OF THE INVENTION

According to an embodiment of the present invention, methods and systems are provided for achieving a fully and tightly controlled process and system for fabricating thin film structures by generating and consuming reactive or difficult-to-handle precursors, utilizing real-time and *in situ* analysis and control, and enabling complete coupling and integration of the precursor synthesis process/system with the thin film formation process/system. The integrated synthesis, delivery and processing of source chemicals is an enabling embodiment for reproducible and reliable thin film fabrication.

Embodiments of the present invention may be applied in any manufacturing process in any industrial setting, including, but not limited to, the semiconductor (computer chip), aircraft, energy, sensor, medical, biological, chemical, and defense industrial sectors.

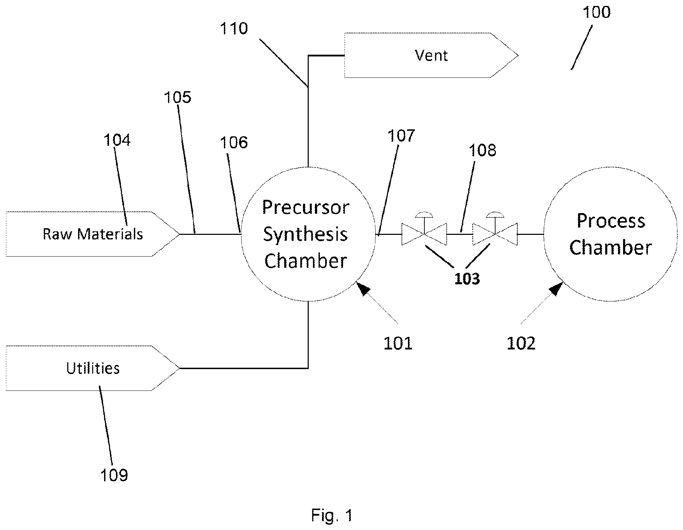

Referring to Fig. 1, there is shown a schematic drawing of an integrated precursor synthesis (i.e., generation) and thin film deposition system 100 comprising a first chamber 101 connected to a second chamber 102, and more particularly a precursor formation chamber 101 connected under controlled conditions to a thin-film processing chamber 102. In one embodiment, the present invention thus relates to the integration of one or more precursor formation chambers or modules 101 with one or more process (e.g., deposition, etching, patterning, implantation and the like) chambers or modules 102. In another embodiment, the present invention relates to a process for precursor formation carried out in tandem with a process for thin film formation, etching, implantation, or patterning. In another embodiment, the present invention relates to the tandem configuration of a precursor formation chamber 101 (or precursor synthesis vessel or precursor synthesis chamber, these terms being used interchangeably herein) physically interfaced with a processing chamber 102, where the processing chamber 102 is either a stand-alone processing chamber or part of an ensemble of processing chambers. The effluent or product of the precursor formation chamber 101 is directly transported via a conduit or manifold system to the tandem processing chamber 102. As such, the generation of precursor is controlled, not only to optimize synthesis, but also to regulate efficient deposition of the precursor on the substrate in the processing chamber(s). The present invention enables reliable fabrication of both new thin film structures and extends the conditions under which traditional thin films can be fabricated.

The precursor formation chamber 101 may have one or more inputs needed to effect its operation, including inputs for raw materials 104, utilities 109 such as electrical power, and electronic monitoring and control instrumentation to manage and control the operation of the precursor formation chamber 101. More particularly, the integrated system 100 further comprises a raw material source 104 and associated feed system which delivers the base or raw materials for the precursor to the precursor formation chamber 101 in a controlled manner (utilizing various control utilities 109, such as electrical power, vacuum, heat, cooling, radiation and the like) via a first conduit 105 (i.e., a raw material supply conduit) and raw material inlet 106, for synthesis of the precursor in the precursor formation chamber 101. The precursor formation chamber 101 is thus not merely a storage container for the precursor, but rather is a reactor in which the precursor material is generated from the raw material supplied thereto.

The precursor formation chamber 101 further includes a precursor outlet 107 through which the generated precursor is supplied or transported from the precursor synthesis chamber 101 to the processing chamber 102. More particularly, the precursor exits the precursor formation chamber 101 through the outlet 107 and is then transported in solid, liquid or vapor form in a precisely controlled manner (utilizing various control utilities 109, such as electrical power) via a second conduit 108 (i.e., a precursor transport conduit) to the processing chamber 102, where the synthesized precursor is processed to grow, etch, implant, or pattern a thin film from the precursor. As such, the precursor formation chamber 101 and the processing chamber 102 are connected to and in direct communication with each other.

In another embodiment (not shown), instead of distinct and separate chambers separated by a conduit, the precursor formation chamber and the processing chamber may constitute different chambers, zones or areas of a single tank, and may be separated from each other in the tank by a common wall or partition. In such an embodiment, the wall or partition preferably includes a through-aperture equipped with a valve and controls for selectively isolating the chambers from each other, or enabling flow of the precursor from the precursor synthesis chamber to the processing chamber. Thus, despite the absence of the precursor transfer conduit, the precursor synthesis chamber and the processing chamber would still be connected to and in direct communication with each other.

In one embodiment, the precursor formation chamber 101 is preferably a precursor synthesis chamber. The precursor formation chamber 101 is referred to hereinafter, in the alternative, as a precursor synthesis chamber.

In one embodiment, the raw material supply conduit 105, the precursor transport conduit 108, the precursor synthesis chamber 101 and/or the processing chamber 102 is/are equipped with one or more valve assemblies 103 and electronic sensors (not shown) for end-point, real-time, *in-situ* monitoring and detection of raw material delivery, precursor delivery, thin film processing, and processing of by-products. For example, such valves 103 and sensors enable the precursor to flow in a reliable, controlled, and consistent fashion from the precursor synthesis chamber 101 to the thin film processing chamber 102. The valve system also effectively isolates the precursor synthesis chamber 101 from the processing chamber 102. More particularly, in one embodiment, the valve system includes one or more valves 103 that employ devices, such as O-rings or metal gaskets, to effectually separate the environment of the two chambers 101, 102.

The precursor synthesis chamber 101 may also have a facility, system, or manifold 110, by which to vent materials not necessary or even deleterious to the precursor synthesis. Such materials may include fluids used to purge the chamber 101, synthesis reaction by-products that might be produced during start-up of the chamber 101 or as a result of process disturbances, and/or manufactured precursor with quality outside control limits or thin film fabrication or modification demand.

The precursor synthesis chamber 101 may also be equipped with *in-situ* and *ex-situ* monitoring and detection techniques, spectroscopies, and spectrometries to monitor and control the various parameters of the precursor synthesis process. Such parameters may include, but are not limited to, temperature, pressure, flow rates of the raw materials and the precursor, and all operating conditions of the chemical synthesis generation itself. The electronic sensors and *in-situ* and *ex-situ* monitoring and detection techniques, spectroscopies, and spectrometries also enable end-point, real-time, *in-situ* monitoring and detection. These facilities also enable interaction between, coupling of and a closed feedback loop between the precursor synthesis parameters, the thin film processing parameters, and the reaction by-products and effluents parameters. More particularly, the present invention allow closed-loop precursor synthesis and thin film processing by using *in situ* and/or *ex situ* embedded sensors to control and manage the link between precursor generation/synthesis, precursor consumption, and thin film processing. In some embodiments, the sensors include, but are not limited to, optical, acoustical, electrical (e.g., sheet resistance), electronic, magnetic, mechanical, electro-mechanical, and electro-magnetic sensors.

Further, the present invention therefore ensures accurate and controlled management of precursor characteristics, such as generation and feed rates into the processing chamber 102; thin film formation characteristics, such as thickness and composition; and reaction by-products and processing chamber effluents characteristics, such as chemical composition and flow rates. In some embodiments, the monitoring and detection techniques include, but are not limited to, ellipsometry and mass spectrometry, and infrared, near infrared, optical, and ultra-violet spectroscopy. In one embodiment a comparative assessment can be performed of the amount or concentration of precursor exiting the thin film processing or formation chamber 102 versus the amount or concentration of precursor exiting the precursor synthesis chamber 101, the differential being incorporated in an algorithm to control the rate of precursor generation in the precursor formation chamber 101 and/or transport and delivery into the thin film fabrication chamber 102. In a preferred embodiment, the amount of precursor generation in the precursor formation/synthesis chamber 101 is controlled by an algorithm that takes into account thin film properties, such as elliposometric thickness or sheet resistance.

The precursor synthesis and thin film deposition processes may be carried out in tandem or concurrently, wherein feedback from one of the chambers 101, 102 controls operation of the other chamber 101, 102. For example, the thin film formation in the second chamber 102 (e.g., the processing chamber or deposition chamber, these terms being used interchangeably herein) is monitored, preferably continuously monitored, and feedback is communicated to the precursor synthesis chamber 101 for controlling the formation/synthesis of the precursor. In the simplest case, if there is no precursor demand in the deposition chamber 102, then the generation of precursor in the precursor synthesis chamber 101 is halted. That is, the generation of the precursor is coupled to the demand of thin film formation, and is matched with the introduction of co-reactants entering the deposition chamber 102. Thus, there is two-way communication between the precursor synthesis chamber 101 and the deposition chamber 102, with operation of both chambers 101, 102 being controlled by a controller based on monitored parameters of each chamber 101, 102.

In some embodiments, the manufacturing technique is one of chemical vapor deposition (CVD), atomic layer deposition (ALD), liquid-phase plating, etching (including atomic layer etching and partial and complete material removal processes), or patterning (i.e., forming a pre-defined structure into an already deposited layer, such as transistor patterns into a silicon substrate).

In some embodiments, the controlled environment under which the precursor synthesis chamber 101 is connected to the processing chamber 102 is one of vacuum, inert gas, hydrogen, reactive gas, or a combination of such gases.

In some embodiments, the processing chamber 102 is a batch tool where a manufacturing technique is applied to multiple wafers concurrently in a single manufacturing apparatus. In other embodiments, the processing chamber 102 is a stand-alone tool where a manufacturing technique is applied to a single wafer in an individual piece of equipment.

In some embodiments, the precursor molecule is volatized or evaporated and transported into the processing chamber 102 using its own vapor pressure, while in other embodiments, the precursor molecule is transported using an inert or reactive carrier gas. The precursor may be in the form of a liquid, solid, or gas.

In some embodiments, the precursor synthesis chamber contains a method of separating byproduct chemicals such as a selective adsorption bed such as activated carbon, molecular sieve or metal-organic framework that removes the byproduct from the vapor transport stream.

In a particularly preferred embodiment, the present invention relates to the tandem generation and consumption of toxic materials in an integrated fashion within a precursor synthesis reactor that is connected to a metal deposition chamber. For example, nickel carbonyl is a precursor for nickel thin films and is representative of a metallization process that can be performed in a tandem precursor generation cluster tool.

Nickel carbonyl is highly toxic and is carcinogenic on a ppm level. Depending on local regulations, the transport and storage of nickel carbonyl is either highly restricted or entirely prohibited. In addition, nickel carbonyl has only limited stability, decomposing slowly even at room temperature to form nickel and carbon monoxide. In an embodiment of the present invention, bulk metallic nickel is loaded into the precursor synthesis chamber 101. A preferred form of nickel is a partially sintered nickel monolith that retains porosity. The chamber 101 is sealed and then appropriately purged and evacuated to eliminate adsorbed and residual gases. The monolith of nickel is then heated to a temperature of 80°C to 120°C. At this stage, a flow of carbon monoxide is initiated concomitant with the opening of a valve in the precursor transport conduit 108, thereby enabling flow from the precursor synthesis chamber 101 to the deposition chamber 102. The connection to the deposition chamber 102 has a detector system, for example near infrared, which can detect and quantify the presence of the precursor (i.e., nickel carbonyl) in the deposition chamber 102.

In the deposition chamber 102, a substrate (not shown) is heated to a temperature in the range of 180°C to 250°C. The nickel carbonyl decomposes on the substrate to form a high purity nickel film. Data from the nickel carbonyl observation window and deposition chamber control are utilized in the rate of formation of nickel carbonyl to adjust (preferably by a controller) the temperature of the sintered nickel monolith and/or the rate of carbon monoxide flow. The ratio of excess carbon monoxide both entering and/or leaving the deposition chamber 102 can be measured by process controls and adjusted to achieve optimum rates of deposition and optimum film properties.

Under analogous conditions, cobalt films can be formed.

Another embodiment of the present invention relates to the formation of silicon nitride at low temperatures utilizing hydrazoic acid. Hydrazoic acid, also known as hydrogen azide, can decompose explosively when stored in bulk and has a toxicity that is comparable to cyanide. Hydrazoic acid decomposes at relatively low temperatures to form radical nitrogen products, including nitrenes which can insert into Si-H bonds. Within the deposition chamber 102, silicon nitride films can be formed by nitriding of amorphous hydrogenated silicon or by reacting both hydrazoic acid and silane (or higher polysilanes) with the substrate in the deposition chamber 102. In the present invention, for example, hydrazoic acid is formed in the tandem deposition chamber 102 as a vapor in low concentration with an appropriate inert carrier gas. One preferred method of generating hydrazoic acid is to have a high boiling hydroxylic liquid in the precursor synthesis chamber 101, with a bottom gas inlet below the liquid level and a gas exit above the liquid. Trimethylsilylazide is entrained in a gas stream which enters the hydroxylic liquid which has been heated to a temperature of 40-65°C. The trimethylsilylazide reacts with the hydroxylated liquid, forming, for example, non-hazardous trimethylsilylstearyl alcohol as it generates hydrazoic acid. The hydrazoic acid, entrained in the carrier gas, then enters the deposition chamber 102 where it can react with amorphous hydrogenated silicon substrates at 325°-500° to form silicon nitride. As in the previous embodiment, the generation rate of hydrazoic acid in the precursor synthesis chamber 101 is matched to its consumption rate in the deposition chamber 102 by appropriate control mechanisms. An alternate method of generating hydazoic acid is to generate the material continuously at elevated temperatures by a thermally driven retro Diels Alder reaction of a compound such as 4, 7-methano-3a, 4, 5, 6, 7, 7a-hexahydrobenzotriazole.

Further, it will be understood by those skilled in the art that one or more of the above-described steps of the examples utilizing nickel carbonyl or hydrazoic acid may be employed with any known precursor and the system/method of the present invention.

The present invention also has great utility where the time-scale of stability of precursor reactants is much shorter and their utilization is limited solely by this factor, not toxicity. Graphene films, for example, are difficult to grow and modify. One such method may be to form benzyne. The stability of benzyne at temperatures above 100°C at moderate concentrations is in the order of seconds. Benzyne can be formed from intermediates such as 2-(trimethylsily)phenyltrifluoromethanesulfonate. In this embodiment, the inert gas entrained compound is passed through a heated block at an elevated temperature in the tandem precursor generation chamber 101 to form benzyne and the by-product trimethysilyltrifluoromethanesulfonate. The by-product is not reactive with graphene, while benzyne reacts with graphene, thereby extending the polycyclic structure.

In another embodiment, the synthesis of the precursor can be generated by linked consumption to electrochemical synthesis. Examples of toxic precursors that can be generated include arsine, phosphine, germane and hydrogen selenide. Relatively unstable precursors, such as stannane, can also be similarly generated in coordination with consumption.

In another embodiment, two reactant gases and optionally one carrier gas are introduced into the precursor synthesis chamber 101, the effluent of which proceeds to the thin film processing chamber 102. The precursor synthesis chamber comprises a series of chambers which allow mixing, potentially including static mixers, and that may be provided with heating or cooling mechanisms. Under appropriate pressure, the carrier gas and one of the reactant gases are introduced into the first stage of a static mixing chamber, as controlled by a mass flow meter. Prior to the next static mixing element, the second reactant gas is introduced to the synthesis stream, again under the control of a mass flow meter. If the reaction is highly exothermic, it may be necessary to provide cooling to the second stage. However, at a minimum, both stages are under thermal control either by a jacket with circulating liquid or another known thermal control method. Upon leaving the static mixing elements, a residual gas analysis (RGA), mass spectra, NIR (near infrared) or UV analysis analyzes the product stream.

Through appropriate valving, the stream is at first diverted to an abatement process. However, as soon as the proper ratio for precursor is achieved, the passage of the stream goes directly to the processing chamber 102, where utilization of the active component is monitored. When the film process is complete, as measured by ellipsometry, sheet-resistance or other appropriate parameter, the introduction of reactant gases to the precursor synthesis chamber 101 is halted by a control loop that closes a valve located before the mass flow meters. Preferably, a by-product removal stage is included in the process stream as part of the precursor synthesis chamber 101. The by-product removal element can include, for example, a low temperature trap, an adsorption step or a distinct chemical reaction process specific to the byproduct.

In another embodiment, particularly where monosilylamine is utilized for silicon nitride deposition, monosilylamine and ammonia reactant (which can act also as a carrier gas) or alternatively nitrogen (which can act as a distinct carrier gas) are introduced into the first stage of the static mixer. Upon leaving the first stage as a homogeneous mixture, monochlorosilane is introduced into the stream before the second static mixing element. Mass flow meters control the amount and concentration of monosilylamine formed in the second static mixing element by utilizing the analytical information obtained by RGA. Either prior to or after the analysis, by-product ammonium chloride can be removed by passing the process stream through a packed bed of pelletized charcoal that would preferably cooled to a temperature below -10°C. However, in some cases, this step is not necessary since the ammonium chloride can pass directly through the thin film processing chamber 102 without affecting the deposition process.

In another embodiment, two interconnected sub-chambers behave as one precursor synthesis chamber 101. The purpose of the first sub-chamber is to entrain a liquid reactant into a gas stream that conveys the reactant under control to the second sub-chamber, where the reaction occurs by reacting with a relatively non-volatile material, thus forming a volatile precursor that proceeds under controlled conditions to the thin film process chamber 102. By-products are retained within the second sub-chamber. It should be noted that the reactant volume of the first sub-chamber is depleted, but the second sub-chamber is not necessarily depleted since it contains the by-products. The first sub-chamber may be considered similar to what in the art is referred to as a bubbler, in which a container is charged with a volatile liquid and a dip tube which allows introduction of a gas below the surface of the liquid reactant, and as the gas proceeds through the liquid phase, it entrains the liquid in a vapor stream which exits the chamber above the level of the liquid. The amount of the entrained reactant is controlled by the rate of carrier gas passing through the bubbler and the temperature of the liquid in the sub-chamber. The entrained reactant then passes through a dip-tube to a second sub-chamber that functions as a reactor. The reaction chamber is configured with a dip tube and is typically heated with stirring and includes a vapor phase exit that connects to the thin film processing chamber 102. The reaction chamber is charged with a second non-volatile reactant. In a preferred embodiment, the contact time with the entrained reactant is sufficient to ensure that there has been complete consumption of the volatile reactant and that the gas stream leaving the reaction chamber contains the carrier gas and a volatile precursor for thin film synthesis.

As presented here, the charged reactants and by-products, except for the mass entrained by the carrier gas, are the only materials that leave the precursor synthesis chamber 101. However, an obvious extension of this concept is to replenish and replace reactive materials and by-products in the precursor synthesis chamber 101 in a controlled process.

One such embodiment involves hydrazoic acid (hydrogen azide), wherein trimethylsilylazide is charged to a bubbler. The second sub-chamber is charged with stearyl alcohol (octadecanol) and heated to a temperature >60°C (greater than the melting point of stearyl alcohol) and stirred. A nitrogen stream entrains the trimethylsilylazide, which reacts with the stearyl alcohol to form the volatile precursor hydrazoic acid, which is entrained with the nitrogen carrier gas to the thin film processing chamber 102. The by-product stearyloxytrimethylsilane is not volatile and remains in the reaction chamber.

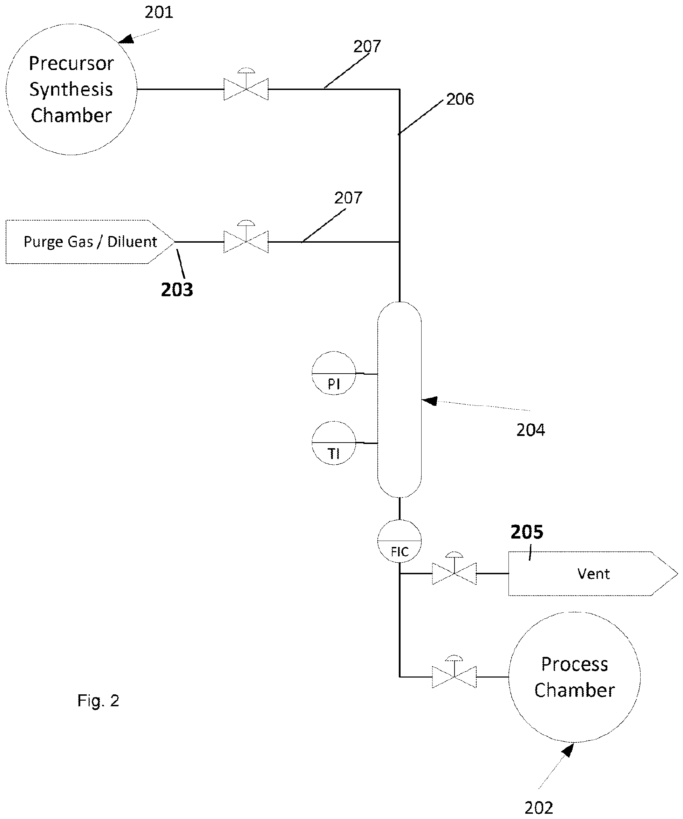

It will be understood that the above discussion regarding Fig. 1 and associated preferred embodiments is equally applicable to Figs. 2-7, a detailed discussion of which follows.

Referring to Fig. 2, there is shown a schematic diagram of a system comprising a precursor synthesis chamber 201 supplying a gas-phase precursor and connected to a thin-film processing chamber 202, via a manifold system 206 that is suitably equipped to deliver a gaseous, liquid, or solid precursor in gas or vapor form. The raw or base material(s) for the precursor is supplied from a raw material source (not shown). The manifold system 206 may include an electronic mass flow meter or a solid or liquid delivery system. The manifold system 206 could also encompass additional equipment and controls, such as a purge gas system 203 and a corresponding vent system 205 to effect purging and/or evacuating of the conduit or piping 207 connecting the precursor synthesis chamber 201 and the thin-film processing chamber 202.

In one embodiment, the manifold system 206 may also include various mechanisms and controls, generally identified as 204, to condition the gas, for example by including an electronic ballast to smooth out variations in the precursor feed, filtration of particulates, or adsorption of impurities that may be generated in the transfer from precursor synthesis chamber 201 to the processing chamber 202. The transfer process may also involve additional mechanisms for monitoring and controlling the transfer, for example, temperature, pressure, and flow rate.

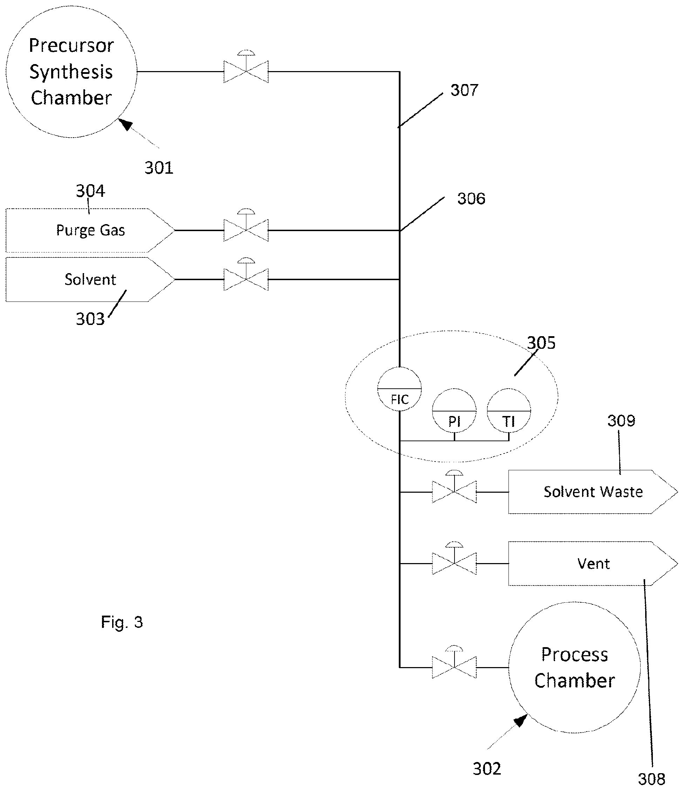

Referring to Fig. 3, there is shown a schematic drawing of a precursor synthesis chamber 301 supplying or delivering a liquid phase precursor to a thin-film processing chamber 302 via a manifold system 306 that is suitably equipped to deliver a liquid phase precursor. The precursor may be in solid or liquid form, supplied from a raw material source (not shown), with the solid precursor being subjected to a liquification or a melting process, or being dissolved in a suitable liquid or solvent prior to delivery to the thin-film processing chamber 302. Additional equipment and controls of the manifold system 306 include a solvent system 303 to clean or remove residual precursor from the lines (i.e., transfer conduit) 307, a purge system 304 to remove residual solvent from the transfer conduit 307, a corresponding vent system 308 to effect purging and/or evacuating of the transfer conduit 307, and a solvent waste component 309. Various instruments and controls 305 may also be included to manage and control the delivery of the proper amount of precursor at the proper purity to the processing chamber 302. Such equipment may include instruments to monitor temperature, pressure and flow, treat that the precursor to remove particulates or other impurities, or vaporize the liquid precursor immediately prior to introduction into the thin-film process chamber 302.

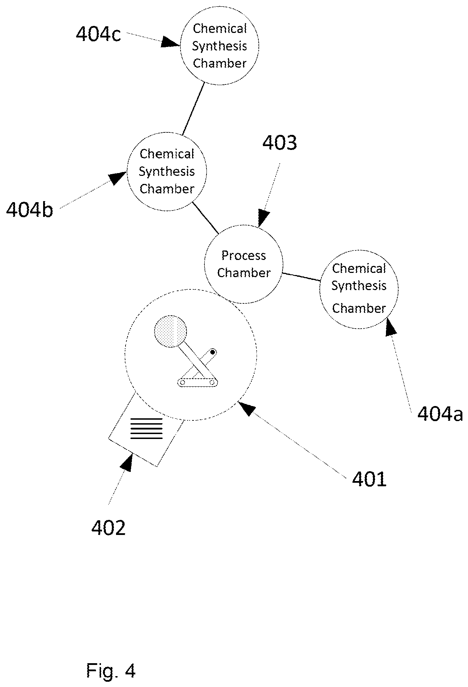

Referring to Fig. 4, there is shown a schematic diagram of an embodiment of a system comprising multiple precursor synthesis chambers 404a, 404b, 404c connected under a controlled environment to a single thin-film manufacturing station or processing chamber 403. Multiple precursors are synthesized in the precursor synthesis chambers 404a-404c, and are then transported concurrently or sequentially to the processing chamber 403, where they are consumed in a manufacturing (e.g., deposition) technique. The precursor synthesis chambers 404 may be configured with respective gas or liquid delivery systems, or other subsystems, as described above with respect to Figs. 1-3, as may be required for the overall operation of the system.

The precursor synthesis chambers 404a-404c may be arranged in a variety of configurations. For example, some or all of the precursor synthesis chambers 404a-404c may be arranged in parallel (i.e., see chambers 404a and 404b in Fig. 4), such that a single or multiple precursors are delivered concurrently from each chamber 404a-404c at the same time to the deposition chamber 043. Alternatively, some or all of the precursor synthesis chambers 404a-404c may be configured in a tandem or in-series arrangement (i.e., see chambers 404b and 404c in Fig. 4), wherein a single or multiple precursors are delivered from one synthesis chamber (i.e., chamber 404c in Fig. 4) to a second synthesis chamber (i.e., chamber 404b in Fig. 4) in sequence, with the resulting mixture of precursors then being delivered to the processing chamber 403. The configurations could also include any other arrangement that can be constructed by combinations of parallel and tandem arrangements. Also, parallel arrangements of the chambers can be operated sequentially, simultaneously, or any other combination as needed, in order to produce a desired effect in the thin-film process chamber 403. A wafer handling system 401 is also provided to move substrate wafers between the storage cassette 402 and the thin-film process chamber 403.

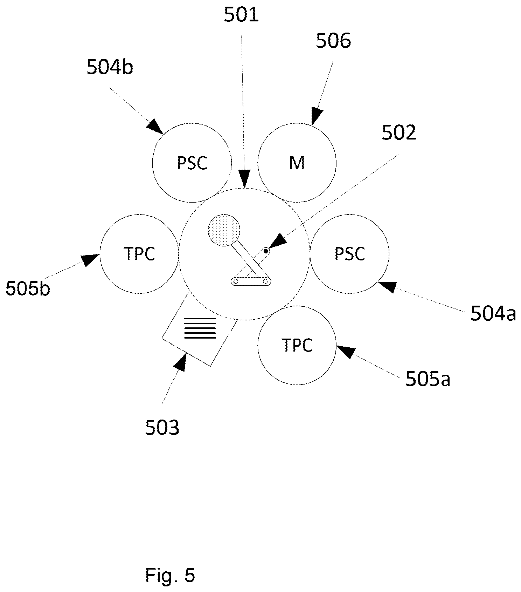

Referring to Fig. 5, there is shown a schematic illustration of an embodiment of a system comprising a plurality of precursor synthesis chambers (PSC) 504a, 504b in fluid communication with a plurality of thin-film processing chambers (TPC) 505a, 505b. Each of the precursor synthesis chambers 504a, 504b is equipped with a gas or liquid delivery system, as described above with respect to Figs. 1-3. The wafer handling system 501 of Fig. 5 includes a mechanism 502, in this example a robotic arm, for transporting substrate wafers among a storage cassette 503, the various thin-film processing chambers 505a, 505b, and one or more metrology (M) chambers 506 used to monitor the characteristics of each substrate wafer as it progresses through the processing chambers 505a, 505b. The precursor synthesis chambers 504a, 504b are configured to produce the same precursor, different precursors, or any combination thereof. The mode of operation of the system is established such that the substrate wafers can visit only one of the thin-film processing chambers 505a, 505b, or any combination of the thin-film processing chambers 505a, 505b, as may be required for overall process optimization or to manufacture a single or multi-layered film or structure. The manufacturing process could include a single processing step such as film deposition, etching, ion implantation, or patterning, or consist of a combination of processing steps, such as an entire set or a subset of deposition, etching, ion implantation and patterning processes.

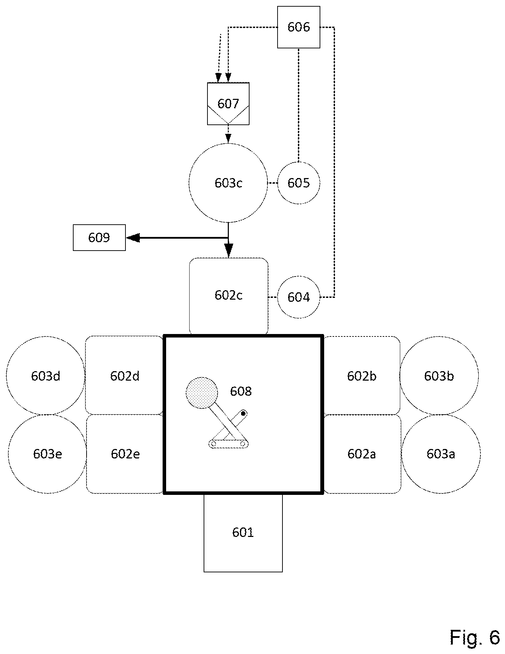

Referring to Fig. 6, there is shown an embodiment of a cluster tool comprising a plurality of integrated precursor synthesis chambers or generators 603a, 603b, 603c, 603d, 603e and thin-film processing chambers 602a, 602b, 602c, 602d, 602e positioned around a central, automated handling unit, with fixed inputs of precursors which supply each processing chamber 602a, 602b, 602c, 602d, 602e. Effluent from a precursor synthesis chamber 603a, 603b, 603c, 603d, 603e can be directed away from the thin-film process chamber 602a, 602b, 602c, 602d, 602e to a safe location (e.g., a scrubber) 609, until such time that the thin-film process chamber 602a, 602b, 602c, 602d, 602e has been fully conditioned and is ready for the introduction of the precursor, and the precursor has been determined to exhibit the specifications and characteristics required by the thin-film manufacturing process.

Substrate wafers are transported from the storage cassette 601 via a robotic arm 608 or other automated system to the thin-film processing chambers 602a, 602b, 602c, 602d, 602e (or other chambers as might be included for the overall utility of the cluster tool). The precursor synthesis chambers 603a, 603b, 603c, 603d, 603e are each connected to a raw material source via a conduit (not shown) as described above with respect to Fig. 1, and may be configured with advanced techniques to control the precursor synthesis to maintain, for example, specific precursor purity and flow rate to the thin-film process chamber 602a, 602b, 602c, 602d, 602e.

Referring to Fig. 6, a concept of such a control loop is provided for one precursor synthesis chamber 603c, but it will be understood that such a control loop may be applied to any one or multiple of the other precursor synthesis chambers 603a, 603b, 603d, 603e, either in identical fashion or in a modified protocol to meet varying control objectives for the different precursors or thin-film manufacturing processes. Specifically, in the control loop shown in Fig. 6, a signal or signals are read from one or multiple instruments 604, 605 in the thin-film process chamber 602c, the precursor synthesis chamber 603c, or both. For example, the thin-film process chamber 602c may be equipped with a process chamber sensor 604 and the precursor synthesis chamber 603c may be equipped with a chemical generator sensor 605. Signals from these sensors 604, 605 are processed through a function block 606 to provide input to a controller 607 (and more particularly a chemical generator controller) that adjusts the operation of the precursor synthesis chamber 603c to meet production objectives. Such instruments may include electronic sensors for end-point, real-time, *in-situ* monitoring and detection and/or *in-situ* and *ex-situ* monitoring and detection techniques, spectroscopies, and spectrometries to monitor and control the various parameters of the precursor synthesis process.

In some embodiments, the system comprises one or more interconnected fabrication or processing chamber or chambers set up sequentially or in-series, wherein the manufacturing technique is applied to a continuous substrate, with the substrate moving sequentially through and from one chamber to the next chamber where it is subject to one or more manufacturing techniques. One example of such an embodiment is roll-to-roll coating of a continuous film on a flexible substrate. In one such embodiment, one or more precursor synthesis modules or chambers are connected to the fabrication or processing chambers, and the precursor or precursors are delivered to the flexible substrate or sprayed on the flexible substrate either in vapor or liquid form where they are decomposed or processed to yield a film on the flexible substrate.

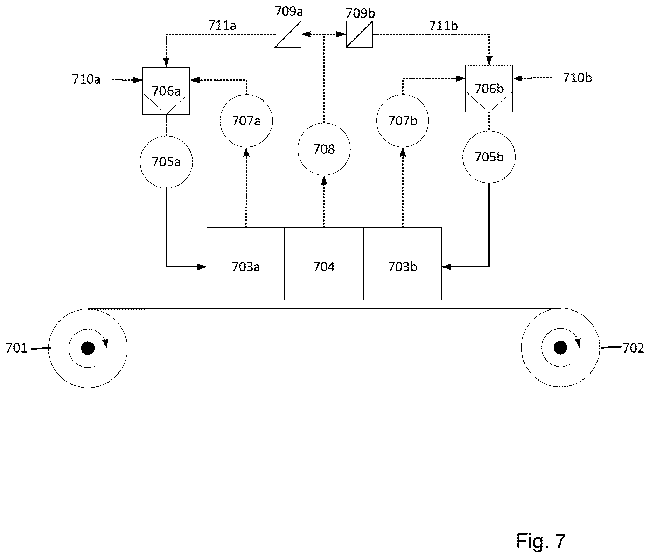

More particularly, referring to Fig. 7, there is shown a schematic drawing of the application of a manufacturing technique to a flexible substrate in the form of a continuous roll or coil (e.g., a ribbon, roll, or spool), rather than in the form of discrete or separate units (e.g., wafers). The stock roll 701 of the flexible substrate is unrolled or unfolded, and fed in a controlled fashion into one or more interconnected fabrication or processing chamber or chambers 703a, 703b arranged sequentially or in-series, and exposed to a series of one or more manufacturing techniques designed to produce a target thin-film structure on the flexible substrate. The manufacturing techniques may comprise the same processing step, such as film deposition, etching, ion implantation, or patterning. Alternatively, the manufacturing techniques may comprise a combination of processing steps, such as an entire set of a subset of deposition, etching, ion implantation and patterning processes, each within its own processing or manufacturing chamber.

The manufacturing techniques are preferably isolated from one another and enclosed each within its own processing chamber 703a, 703b. One or more intervening chambers 704 (e.g., a metrology chamber) is/are preferably provided to enhance isolation and/or process control. Each process chamber 703a, 703b is associated with one or more precursor synthesis chambers 705a, 705b. The precursor synthesis chambers 705a, 705b can all deliver the same precursor to every individual fabrication or processing chamber 703a, 703b, either in vapor or liquid form, where the precursor is decomposed or processed or consumed totally or partially to yield a film on the flexible substrate. Alternatively, each precursor synthesis chamber 705a, 705b can deliver a different precursor to the corresponding fabrication or processing chamber 703a, 703b, either in vapor or liquid form where each precursor is decomposed or processed or consumed totally or partially to yield a layer of a multi-layered film on the flexible substrate.

A control manifold comprising measurement instruments 707a, 707b and 708, and converter process models 709a, 709b in communication with process controllers 706a, 706b via lines or conduits 711a, 711b, is incorporated to provide feedback and feedforward control to the individual precursor synthesis chambers 705a, 705, in order to meet given preset processing set points 710a, 710b. The resulting processed flexible substrate is spooled back on an end roll 702. In one embodiment, the instruments 707a, 707b are *in-situ* sensors and the instrument 708 is an *ex-situ* sensor. In one embodiment, process controllers 706a, 706b are chemical source (i.e., precursor) controllers and converter process models 709a, 709b are signal converters.

In some embodiments, the precursor or precursors are decomposed or processed on the flexible substrate using a sol-gel or plating technique to form a layer or film. In other embodiments, the precursor is decomposed or processed on the flexible substrate using CVD or ALD techniques. In other embodiments, the resulting film comprises a single uniform layer or multiple layers, depending on the number of different precursors used.

It will be appreciated by those skilled in the art that changes could be made to the embodiments described above without departing from the broad inventive concept thereof. It is understood, therefore, that this invention is not limited to the particular embodiments disclosed, but it is intended to cover modifications within the scope of the present invention as defined by the appended claims.

## Claims

1. A system (100) for synthesis of a film-forming precursor and consumption of the precursor by formation of a thin film on a substrate, the system (100) comprising:
a raw material source (104) containing at least one raw material;
a precursor synthesis chamber (101, 201, 301) including an inlet (106) and an outlet (107), the inlet (107) of the precursor synthesis chamber being in communication with the raw material source (104) for supplying the raw material to the precursor synthesis chamber (101, 201, 301) where it is reacted to synthesize a precursor; and
a thin film processing chamber (102, 202) connected with the precursor synthesis chamber (101, 201, 301), the thin film processing chamber (102, 202) including an inlet in direct communication with and coupled to the outlet of the precursor synthesis chamber (102, 202) in an controlled manner for supplying the precursor from the precursor synthesis chamber (102, 202) to the thin film processing chamber (101, 201, 301) in a controlled manner for consumption of the precursor to form the thin film on the substrate in the thin film processing chamber (102, 202);
a monitoring system (604, 605) for real-time monitoring and detection of the thin film formation in the thin film processing chamber (102, 202) and the precursor synthesis in the precursor synthesis chamber (101, 201, 301); and
a controller (607) for: (i) receiving data from the monitoring system (604) regarding the precursor consumption and thin film formation and transmitting the data to the precursor synthesis chamber (101, 201, 301) for controlling a rate of the precursor synthesis to ensure that the rate of precursor synthesis matches the rate of the precursor consumption and thin film formation, and
(ii) receiving data from the monitoring system (605) regarding the precursor synthesis and transmitting the data to the thin film processing chamber (102, 202) for controlling rates of the precursor consumption and thin film formation to ensure that the rates of precursor consumption and thin film formation match the rate of precursor synthesis.

2. The system (100) of claim 1, wherein the controller (607) is configured to compare an amount or concentration of the precursor entering the thin film processing chamber (102, 202) with an amount or concentration of the precursor exiting the precursor synthesis chamber (101, 201, 301) to calculate a differential, and to utilize the differential as part of an algorithm to control the rate of precursor synthesis in the precursor synthesis chamber (101, 201, 301).

3. The system (100) of claim 1, wherein the system (100) is a feedback loop system comprising the precursor synthesis chamber (101, 201, 301) and the thin film processing chamber (102, 202) connected thereto, and wherein the monitoring system and the controller control (607) and manage the communication between the precursor synthesis in the precursor synthesis chamber (101, 201, 301) and the precursor consumption to form the thin film formation in the thin film processing chamber (102, 202).

4. The system (100) of claim 1, wherein the controller (607) adjusts the rate of precursor synthesis based on the rate of the precursor consumption.

5. The system (100) of claim 1, wherein the monitoring system comprises at least one of in-situ monitoring and detection techniques, ex-situ monitoring and detection techniques, spectroscopies, and spectrometries, to monitor at least one parameter selected from the group consisting of processing parameters of the precursor synthesis chamber, processing parameters of the thin film processing chamber, parameters of reaction by-products and effluents, and the at least one property of the thin film.

6. The system (100) of claim 5, wherein the at least one parameter is selected from the group consisting of temperature, pressure, flow rate of the one or more raw materials of the precursor, flow rate of the precursor and reaction conditions of precursor synthesis.

7. The system (100) of claim 5, wherein the in-situ and ex-situ monitoring and detection techniques include at least one technique selected from the group consisting of ellipsometry, mass spectrometry, infrared spectroscopy, near infrared spectroscopy, optical spectroscopy and ultra-violet spectroscopy.

8. The system (100) of claim 1, wherein the monitoring system (604, 605) comprises at least one in-situ embedded sensor and/or at least one ex-situ embedded sensor for real-time monitoring and detection of the at least one processing parameter of the system (100) and/or the at least one property of the thin film.

9. The system (100) of claim 8, wherein the at least one in-situ embedded sensor and/or the at least one ex-situ embedded sensor is selected from the group consisting of an optical sensor, an acoustic sensor, an electrical sensor, an electronic sensor, a magnetic sensor, a mechanical sensor, an electro-mechanical sensor and an electro-magnetic sensor.

10. The system (100) of claim 8, wherein the at least one parameter is selected from the group consisting of temperature, pressure, flow rate of the one or more raw materials of the precursor, flow rate of the precursor and reaction conditions of precursor synthesis.

11. The system (100) of claim 1, wherein the precursor synthesis chamber (101, 201, 301) and the thin film processing chamber (102, 202) are separate and distinct chambers, and wherein interior environments of the precursor synthesis chamber (101, 201, 301) and the thin film processing chamber (102, 202) are isolated from one another by a valve assembly.

12. The system (100) of claim 1, wherein the precursor synthesis chamber (101, 201, 301) includes a vent outlet to evacuate purge fluids or reaction by-products.

13. The system (100) of claim 1, further comprising a manifold system (206) connecting the outlet of the precursor synthesis chamber (101, 201) with the inlet of the thin film processing chamber (102, 202) for flow of a gas-phase precursor therethrough.

14. The system (100) of claim 13, further comprising a purge gas system (203) and vent system (205) for purging and evacuating conduits of the manifold system (206).

15. The system (100) of claim 1, further comprising a manifold system (306) connecting the outlet of the precursor synthesis chamber (101, 301) with the inlet of the thin film processing chamber (302) for flow of a liquid-phase precursor therethrough.

16. The system of claim 15, further comprising a cleaning system (303) configured to supply a solvent solution to conduits (307) of the manifold system (306) for cleaning of the conduits, and a purge system (304) for removing residual solvent solution from the conduits (307) of the manifold system (306).

17. The system (100) of claim 1, comprising a plurality of precursor synthesis chambers (404a, 404b, 404c) connected with a single thin film processing chamber (403).

18. The system (100) of claim 17, wherein at least two of the plurality of precursor synthesis chambers (404a, 404b, 404c) are configured in a parallel arrangement, such that a precursor is delivered to the single thin film processing chamber (403) concurrently from each precursor synthesis chamber (404a, 404b, 404c) in the parallel arrangement.

19. The system (100) of claim 18, wherein at least two of the plurality of precursor synthesis chambers (404b, 404c) are configured in an in-series or tandem arrangement, such that a precursor from an upstream precursor synthesis (404c) chamber is delivered to a downstream precursor synthesis chamber (404b) to form a mixture of precursors, and subsequently the mixture of precursors is delivered to the single thin film processing chamber (403) from the downstream precursor synthesis chamber (404b).

20. The system (100) of claim 1, comprising a plurality of precursor synthesis chambers (504a, 504b) connected with a plurality of thin film processing chambers (505a, 505b).

21. The system (100) of claim 20, further comprising a storage cassette (503) for storing at least one substrate, a plurality of metrology chambers (506) for monitoring at least one characteristic of the substrate, and a transport mechanism (502) for transporting the substrate among the storage cassette (503), the plurality of thin film processing chambers (505a, 505b) and the plurality of metrology chambers (506).

22. The system (100) of claim 20, further comprising a cluster tool integrated with the plurality of precursor synthesis chambers (603a, 603b, 603c, 603d, 603e) and the plurality of thin film processing chambers (602a, 602b, 602c, 602d, 602e).

23. The system (100) of claim 20, wherein each precursor synthesis chamber (603a, 603b, 603c, 603d, 603e) is connected to a corresponding thin film processing chamber (602a, 602b, 602c, 602d, 602e) for delivering the same precursor to the corresponding thin film processing chamber (602a, 602b, 602c, 602d, 602e) in vapor or liquid form.

24. The system (100) of claim 20, wherein each precursor synthesis chamber (603a, 603b, 603c, 603d, 603e) is connected to a corresponding thin film processing chamber (602a, 602b, 602c, 602d, 602e) for delivering a different precursor to the corresponding thin film processing chamber (602a, 602b, 602c, 602d, 602e) in vapor or liquid form.

25. The system (100) of claim 20, wherein the substrate is a flexible substrate in the form of a continuous roll or coil, such as a ribbon, roll, tape or spool.

26. The system (100) of claim 25, wherein the flexible substrate comprises a stock roll (701) which is unrolled or unfolded, and which is fed in a controlled fashion into one or more of the plurality of thin film processing chambers (703a, 703b) which are connected to each other.

27. The system (100) of claim 26, wherein the interconnected thin film processing chambers apply the same manufacturing technique to the substrate.

28. The system (100) of claim 26, wherein each of the interconnected thin film processing chambers applies a different manufacturing technique to the substrate.

29. The system of claim 1, wherein the precursor is one of nickel carbonyl and hydrazoic acid.

30. The system of claim 1, wherein the thin film processing chamber (102, 602a, 602b, 602c, 602d, 602e) is one of a batch tool, a stand-alone tool, and a cluster tool.

31. A method for synthesis of a film-forming precursor and consumption of the precursor by formation of a thin film on a substrate, wherein said method is executable with a system according to any of the preceding claims, the method comprising:
providing a raw material source (100) containing at least one raw material;
supplying the at least one raw material from the raw material source (100) to a precursor synthesis chamber (101, 201, 301, 404a, 404b, 404c, 504a, 504b, 603a, 603b, 603c, 603d, 603e, 705a, 705b);
reacting the at least one raw material in the precursor synthesis chamber (101, 201, 301, 404a, 404b, 404c, 504a, 504b, 603a, 603b, 603c, 603d, 603e, 705a, 705b) to form a precursor;
supplying the precursor from the precursor synthesis chamber (101, 201, 301, 404a, 404b, 404c, 504a, 504b, 603a, 603b, 603c, 603d, 603e, 705a, 705b) in a controlled manner to a thin film processing chamber(102, 202, 302, 403, 505a, 505b, 602a, 602b, 602c, 602d, 602e, 703a, 703b) , the thin film processing chamber (102, 202, 302, 403, 505a, 505b, 602a, 602b, 602c, 602d, 602e, 703a, 703b) operating in tandem with and being connected to the precursor synthesis chamber (101, 201, 301, 404a, 404b, 404c, 504a, 504b, 603a, 603b, 603c, 603d, 603e, 705a, 705b),
applying a manufacturing technique for consumption of the precursor to form the thin film on a substrate positioned in the thin film processing chamber (102, 202, 302, 403, 505a, 505b, 602a, 602b, 602c, 602d, 602e, 703a, 703b);
performing real-time monitoring and detection of at least one parameter selected from the group consisting of processing parameters of the precursor synthesis chamber (101, 201, 301, 404a, 404b, 404c, 504a, 504b, 603a, 603b, 603c, 603d, 603e, 705a, 705b), processing parameters of the thin film processing chamber (102, 202, 302, 403, 505a, 505b, 602a, 602b, 602c, 602d, 602e, 703a, 703b), parameters of reaction by-products and effluents, and at least one property of the thin film; and
transmitting feedback regarding the precursor consumption and the thin film formation to the precursor synthesis chamber (101, 201, 301, 404a, 404b, 404c, 504a, 504b, 603a, 603b, 603c, 603d, 603e, 705a, 705b) for controlling the synthesis of the precursor, such that (i) synthesis of the precursor occurs concurrently with or in tandem with the thin film formation, (ii) controlling rate of precursor synthesis matches the rate of precursor consumption and the rate of film formation, and (iii) controlling the rate of precursor consumption and the rate of film formation match the rate of precursor synthesis.

32. The method of claim 31, further comprising
comparing an amount or concentration of the precursor entering the thin film processing chamber (102, 202, 302, 403, 505a, 505b, 602a, 602b, 602c, 602d, 602e, 703a, 703b) with an amount or concentration of the precursor exiting the precursor synthesis chamber (101, 201, 301, 404a, 404b, 404c, 504a, 504b, 603a, 603b, 603c, 603d, 603e, 705a, 705b) to calculate a differential, and utilizing the differential as part of an algorithm to control the rate of precursor synthesis in the precursor synthesis chamber (101, 201, 301, 404a, 404b, 404c, 504a, 504b, 603a, 603b, 603c, 603d, 603e, 705a, 705b).

33. The method of claim 31, wherein the manufacturing technique is one selected from the group consisting of chemical vapor deposition (CVD), atomic layer deposition (ALD), liquid-phase plating, etching, atomic layer etching, ion implantation, and patterning.

34. The method of claim 31, wherein supplying of the precursor from the precursor synthesis chamber (101, 201, 301, 404a, 404b, 404c, 504a, 504b, 603a, 603b, 603c, 603d, 603e, 705a, 705b) to the thin film processing chamber (102, 202, 302, 403, 505a, 505b, 602a, 602b, 602c, 602d, 602e, 703a, 703b) is carried out by use of at least one of vacuum, inert gas, hydrogen, reactive gas, or a combination of inert gas and hydrogen reactive gas.

35. The method of claim 31, wherein the precursor is transported to the thin film processing chamber (102, 202, 302, 403, 505a, 505b, 602a, 602b, 602c, 602d, 602e, 703a, 703b) using an inert or a reactive carrier gas.

36. The method of claim 31, wherein the precursor is volatized or evaporated and transported to the thin film processing chamber (102, 202, 302, 403, 505a, 505b, 602a, 602b, 602c, 602d, 602e, 703a, 703b) using its own vapor pressure.

37. The method of claim 31 wherein:
the raw material is metallic nickel which is supplied to a precursor generation chamber(101, 201, 301, 404a, 404b, 404c, 504a, 504b, 603a, 603b, 603c, 603d, 603e, 705a, 705b) ; and wherein the method comprises:
sealing the precursor generation chamber (101, 201, 301, 404a, 404b, 404c, 504a, 504b, 603a, 603b, 603c, 603d, 603e, 705a, 705b);
purging the precursor generation chamber (101, 201, 301, 404a, 404b, 404c, 504a, 504b, 603a, 603b, 603c, 603d, 603e, 705a, 705b) to evacuate adsorbed and residual gases;
heating the bulk metallic nickel to a temperature of 80°C to 120°C;
supplying carbon monoxide to the precursor generation chamber (101, 201, 301, 404a, 404b, 404c, 504a, 504b, 603a, 603b, 603c, 603d, 603e, 705a, 705b) and simultaneously enabling flow communication between the precursor generation system (101, 201, 301, 404a, 404b, 404c, 504a, 504b, 603a, 603b, 603c, 603d, 603e, 705a, 705b) and a downstream and interconnected thin film processing chamber (102, 202, 302, 403, 505a, 505b, 602a, 602b, 602c, 602d, 602e, 703a, 703b), so as to generate the nickel carbonyl precursor and supply the nickel carbonyl precursor directly from the precursor generation chamber (101, 201, 301, 404a, 404b, 404c, 504a, 504b, 603a, 603b, 603c, 603d, 603e, 705a, 705b) to the thin film processing chamber (102, 202, 302, 403, 505a, 505b, 602a, 602b, 602c, 602d, 602e, 703a, 703b);
heating the substrate in the thin film processing chamber (102, 202, 302, 403, 505a, 505b, 602a, 602b, 602c, 602d, 602e, 703a, 703b) to a temperature of 180°C to 250°C, such that the nickel carbonyl precursor decomposes on the substrate to form the nickel thin film;
performing real-time in-situ monitoring and detection of the nickel thin film formation in the thin film processing chamber (102, 202, 302, 403, 505a, 505b, 602a, 602b, 602c, 602d, 602e, 703a, 703b); and
transmitting feedback regarding the nickel thin film formation to the precursor generation chamber (101, 201, 301, 404a, 404b, 404c, 504a, 504b, 603a, 603b, 603c, 603d, 603e, 705a, 705b) for controlling a rate of generation of the nickel carbonyl precursor, such that generation of the nickel carbonyl precursor occurs concurrently with or in tandem with the nickel thin film formation.

38. The method according to claim 31 wherein:
the raw material is a high boiling hydroxylic liquid, which has a higher boiling temperature compared to the synthesized precursor and is supplied to a precursor generation chamber (101, 201, 301, 404a, 404b, 404c, 504a, 504b, 603a, 603b, 603c, 603d, 603e, 705a, 705b), the precursor generation chamber (101, 201, 301, 404a, 404b, 404c, 504a, 504b, 603a, 603b, 603c, 603d, 603e, 705a, 705b) having a gas inlet proximate a bottom end of the chamber below the liquid level and a gas outlet above the liquid level; and wherein the method comprises:
heating the hydroxylic liquid to a temperature of 40°C to 65°C to form a liquid containing hydroxyl groups;
introducing a first stream of trimethylsilylazide entrained in a carrier gas into the precursor generation chamber (101, 201, 301, 404a, 404b, 404c, 504a, 504b, 603a, 603b, 603c, 603d, 603e, 705a, 705b) through the gas inlet, wherein the trimethylsilylazide reacts with the liquid containing hydroxyl groups and generates the hydrazoic acid precursor;
supplying a second stream of the hydrazoic acid entrained in the carrier gas from the precursor generation chamber (101, 201, 301, 404a, 404b, 404c, 504a, 504b, 603a, 603b, 603c, 603d, 603e, 705a, 705b) directly to a thin film processing chamber (102, 202, 302, 403, 505a, 505b, 602a, 602b, 602c, 602d, 602e, 703a, 703b), the thin film processing chamber (102, 202, 302, 403, 505a, 505b, 602a, 602b, 602c, 602d, 602e, 703a, 703b) operating in tandem with and being connected to the precursor generation chamber (101, 201, 301, 404a, 404b, 404c, 504a, 504b, 603a, 603b, 603c, 603d, 603e, 705a, 705b);
heating a silicon substrate in the thin film processing chamber (102, 202, 302, 403, 505a, 505b, 602a, 602b, 602c, 602d, 602e, 703a, 703b) to a temperature of 325°C to 500°C, such that the hydrazoic acid reacts with the silicon substrate to form to form the silicon nitride thin film;
performing real-time in-situ monitoring and detection of the silicon nitride thin film formation in the thin film processing chamber (102, 202, 302, 403, 505a, 505b, 602a, 602b, 602c, 602d, 602e, 703a, 703b); and
transmitting feedback regarding the silicon nitride thin film formation to the precursor generation chamber (101, 201, 301, 404a, 404b, 404c, 504a, 504b, 603a, 603b, 603c, 603d, 603e, 705a, 705b) for controlling the generation of the hydrazoic acid precursor, such that generation of the hydrazoic acid precursor occurs concurrently with or in tandem with the silicon nitride thin film formation.

## Patentansprüche

1. System (100) zur Synthese eines filmbildenden Vorläufers und für den Verbrauch des Vorläufers durch Bildung eines Dünnfilms auf einem Substrat, wobei das System (100) umfasst:
eine Rohmaterialquelle (104), welche zumindest ein Rohmaterial enthält;
eine Vorläufersynthesekammer (101, 201, 301), welche einen Einlass (106) und einem Auslass (107) beinhaltet, wobei der Einlass (107) der Vorläufersynthesekammer mit der Rohmaterialquelle (104) in Kommunikation steht, um das Rohmaterial der Vorläufersynthesekammer (101, 201, 301) zuzuführen, wo es reagiert wird, um einen Vorläufer zu synthetisieren; und
eine Dünnfilmverarbeitungskammer (102, 202), die mit der Vorläufersynthesekammer (101, 201, 301) verbunden ist, wobei die Dünnfilmverarbeitungskammer (102, 202) einen Einlass beinhaltet, der in direkter Kommunikation mit dem Auslass der Vorläufersynthesekammer (102, 202) steht und mit diesem in einer kontrollierten Weise gekoppelt ist, um den Vorläufer von der Vorläufersynthesekammer (102, 202) der Dünnfilmverarbeitungskammer (101, 201, 301) in einer kontrollierten Weise zuzuführen, damit der Vorläufer verbraucht wird, um den Dünnfilm auf dem Substrat in der Dünnfilmverarbeitungskammer (102, 202) zu bilden;
ein Überwachungssystem (604, 605) zur Echtzeitüberwachung und -erkennung der Dünnfilmbildung in der Dünnfilmverarbeitungskammer (102, 202) und der Vorläufersynthese in der Vorläufersynthesekammer (101, 201, 301); und
eine Steuereinheit (607) zum: (i) Empfangen von Daten vom Überwachungssystem (604) bezüglich des Vorläuferverbrauchs und der Dünnfilmbildung und Übertragen der Daten an die Vorläufersynthesekammer (101, 201, 301) zum Steuern einer Rate der Vorläufersynthese, um sicherzustellen, dass die Rate der Vorläufersynthese mit der Rate des Vorläuferverbrauchs und der Dünnfilmbildung übereinstimmt, und
(ii) Empfangen von Daten vom Überwachungssystem (605) bezüglich der Vorläufersynthese und Übertragen der Daten an die Dünnfilmverarbeitungskammer (102, 202) zum Steuern von Raten des Vorläuferverbrauchs und der Dünnfilmbildung, um sicherzustellen, dass die Raten des Vorläuferverbrauchs und der Dünnfilmbildung mit der Rate der Vorläufersynthese übereinstimmen.

2. System (100) nach Anspruch 1, wobei die Steuereinheit (607) dazu konfiguriert ist, eine Menge oder Konzentration des in die Dünnfilmverarbeitungskammer (102, 202) eintretenden Vorläufers mit einer Menge oder Konzentration des aus der Vorläufersynthesekammer (101, 201, 301) austretenden Vorläufers zu vergleichen, um eine Differenz zu berechnen, und die Differenz als Teil eines Algorithmus zu verwenden, um die Rate der Vorläufersynthese in der Vorläufersynthesekammer (101, 201, 301) zu steuern.

3. System (100) nach Anspruch 1, wobei das System (100) ein Rückkopplungsschleifensystem ist, welches die Vorläufersynthesekammer (101, 201, 301) und die damit verbundene Dünnfilmverarbeitungskammer (102, 202) umfasst, und wobei das Überwachungssystem und die Steuereinheit die Kommunikation zwischen der Vorläufersynthese in der Vorläufersynthesekammer (101, 201, 301) und dem Vorläuferverbrauch steuern (607) und verwalten, um die Dünnfilmbildung in der Dünnfilmverarbeitungskammer (102, 202) zu bilden.

4. System (100) nach Anspruch 1, wobei die Steuereinheit (607) die Rate der Vorläufersynthese basierend auf der Rate des Vorläuferverbrauchs anpasst.

5. System (100) nach Anspruch 1, wobei das Überwachungssystem zumindest eines von In-situ-Überwachungs- und -Erkennungstechniken, Ex-situ-Überwachungs- und - Erkennungstechniken, Spektroskopien und Spektrometrien umfasst, um zumindest einen Parameter zu überwachen, der aus der Gruppe bestehend aus Verarbeitungsparametern der Vorläufersynthesekammer, Verarbeitungsparametern der Dünnfilmverarbeitungskammer, Parametern von Reaktionsnebenprodukten und Abwässern und zumindest einer Eigenschaft des Dünnfilms ausgewählt ist.

6. System (100) nach Anspruch 5, wobei der zumindest eine Parameter aus der Gruppe bestehend aus Temperatur, Druck, Durchflussrate des einen oder der mehreren Rohmaterialien des Vorläufers, Durchflussrate des Vorläufers und Reaktionsbedingungen der Vorläufersynthese ausgewählt ist.

7. System (100) nach Anspruch 5, wobei die In-situ- und Ex-situ-Überwachungs- und Erkennungstechniken zumindest eine Technik beinhalten, die aus der Gruppe bestehend aus Ellipsometrie, Massenspektrometrie, Infrarotspektroskopie, Nahinfrarotspektroskopie, optischer Spektroskopie und Ultraviolettspektroskopie ausgewählt ist.

8. System (100) nach Anspruch 1, wobei das Überwachungssystem (604, 605) zumindest einen In-situ-eingebetteten Sensor und/oder zumindest einen Ex-situ-eingebetteten Sensor zur Echtzeitüberwachung und -erkennung des zumindest einen Verarbeitungsparameters des Systems (100) und/oder der zumindest einen Eigenschaft des Dünnfilms umfasst.

9. System (100) nach Anspruch 8, wobei der zumindest eine In-situ-eingebettete Sensor und/oder der zumindest eine Ex-situ-eingebettete Sensor aus der Gruppe bestehend aus einem optischen Sensor, einem akustischen Sensor, einem elektrischen Sensor, einem elektronischen Sensor, einem magnetischen Sensor, einem mechanischen Sensor, einem elektromechanischen Sensor und einem elektromagnetischen Sensor ausgewählt wird.

10. System (100) nach Anspruch 8, wobei der zumindest eine Parameter aus der Gruppe bestehend aus Temperatur, Druck, Durchflussrate des einen oder der mehreren Rohmaterialien des Vorläufers, Durchflussrate des Vorläufers und Reaktionsbedingungen der Vorläufersynthese ausgewählt wird.

11. System (100) nach Anspruch 1, wobei die Vorläufersynthesekammer (101, 201, 301) und die Dünnfilmverarbeitungskammer (102, 202) getrennte und unterschiedliche Kammern sind, und wobei die Innenumgebungen der Vorläufersynthesekammer (101, 201, 301) und der Dünnfilmverarbeitungskammer (102, 202) durch eine Ventilanordnung voneinander isoliert sind.

12. System (100) nach Anspruch 1, wobei die Vorläufersynthesekammer (101, 201, 301) einen Entlüftungsauslass zum Abführen von Spülflüssigkeiten oder Reaktionsnebenprodukten beinhaltet.

13. System (100) nach Anspruch 1, weiter ein Verteilersystem (206) umfassend, welches den Auslass der Vorläufersynthesekammer (101, 201) mit dem Einlass der Dünnfilmverarbeitungskammer (102, 202) verbindet, damit ein Gasphasenvorläufer hindurchströmen kann.

14. System (100) nach Anspruch 13, weiter ein Spülgassystem (203) und ein Entlüftungssystem (205) zum Spülen und Evakuieren von Leitungen des Verteilersystems (206) umfassend.

15. System (100) nach Anspruch 1, weiter ein Verteilersystem (306) umfassend, welches den Auslass der Vorläufersynthesekammer (101, 301) mit dem Einlass der Dünnfilmverarbeitungskammer (302) verbindet, damit ein Flüssigphasenvorläufer hindurchströmen kann.

16. System nach Anspruch 15, weiter ein Reinigungssystem (303), welches dazu konfiguriert ist, den Leitungen (307) des Verteilersystems (306) eine Lösungsmittellösung zum Reinigen der Leitungen zuzuführen, und ein Spülsystem (304) zum Entfernen von Restlösungsmittellösung aus den Leitungen (307) des Verteilersystems (306) umfassend.

17. System (100) nach Anspruch 1, umfassend eine Vielzahl von Vorläufersynthesekammern (404a, 404b, 404c), welche mit einer einzigen Dünnfilmverarbeitungskammer (403) verbunden sind.

18. System (100) nach Anspruch 17, wobei zumindest zwei der Vielzahl von Vorläufersynthesekammern (404a, 404b, 404c) in einer parallelen Anordnung konfiguriert sind, sodass ein Vorläufer gleichzeitig aus jeder Vorläufersynthesekammer (404a, 404b, 404c) in der parallelen Anordnung an die einzelne Dünnfilmverarbeitungskammer (403) geliefert wird.

19. System (100) nach Anspruch 18, wobei zumindest zwei der Vielzahl von Vorläufersynthesekammern (404b, 404c) in einer In-Reihe- oder Tandemanordnung konfiguriert sind, sodass ein Vorläufer aus einer vorgeschalteten Vorläufersynthesekammer (404c) an eine nachgeschalteten Vorläufersynthesekammer (404b) geliefert wird, um eine Mischung von Vorläufern zu bilden, und anschließend die Mischung aus Vorläufern von der nachgeschalteten Vorläufersynthesekammer (404b) an die Dünnfilmverarbeitungskammer (403) geliefert wird.

20. System (100) nach Anspruch 1, umfassend eine Vielzahl von Vorläufersynthesekammern (504a, 504b), welche mit einer Vielzahl von Dünnfilmverarbeitungskammern (505a, 505b) verbunden sind.

21. System (100) nach Anspruch 20, weiter eine Lagerkassette (503) zum Lagern zumindest eines Substrats, eine Vielzahl von Messkammern (506) zum Überwachen zumindest einer Eigenschaft des Substrats, und einen Transportmechanismus (502) zum Transportieren des Substrats zwischen der Lagerkassette (503), der Vielzahl von Dünnfilmverarbeitungskammern (505a, 505b) und der Vielzahl von Messkammern (506) umfassend.

22. System (100) nach Anspruch 20, weiter ein Cluster-Tool umfassend, welches mit der Vielzahl von Vorläufersynthesekammern (603a, 603b, 603c, 603d, 603e) und der Vielzahl von Dünnfilmverarbeitungskammer (602a, 602b, 602c, 602d, 602e) integriert ist.

23. System (100) nach Anspruch 20, wobei jede Vorläufersynthesekammer (603a, 603b, 603c, 603d, 603e) mit einer entsprechenden Dünnfilmverarbeitungskammer (602a, 602b, 602c, 602d, 602e) verbunden ist, um der entsprechenden Dünnfilmverarbeitungskammer (602a, 602b, 602c, 602d, 602e) denselben Vorläufer in Dampf- oder Flüssigkeitsform zu liefern.

24. System (100) nach Anspruch 20, wobei jede Vorläufersynthesekammer (603a, 603b, 603c, 603d, 603e) mit einer entsprechenden Dünnfilmverarbeitungskammer (602a, 602b, 602c, 602d, 602e) verbunden ist, um der entsprechenden Dünnfilmverarbeitungskammer (602a, 602b, 602c, 602d, 602e) unterschiedliche Vorläufer in Dampf- oder Flüssigkeitsform zu liefern.

25. System (100) nach Anspruch 20, wobei das Substrat ein flexibles Substrat in Form einer Endlosrolle oder -spule ist, wie etwa ein Band, eine Rolle, ein Streifen oder eine Spule.

26. System (100) nach Anspruch 25, wobei das flexible Substrat eine Vorratsrolle (701) umfasst, welche abgerollt oder entfaltet wird, und welche auf eine kontrollierte Weise in eine oder mehrere der Vielzahl von Dünnfilmverarbeitungskammern (703a, 703b) eingeführt wird, welche miteinander verbunden sind.

27. System (100) nach Anspruch 26, wobei die miteinander verbundenen Dünnfilmverarbeitungskammern dieselbe Herstellungstechnik auf das Substrat anwenden.

28. System (100) nach Anspruch 26, wobei jede der miteinander verbundenen Dünnfilmverarbeitungskammern eine unterschiedliche Herstellungstechnik auf das Substrat anwendet.

29. System nach Anspruch 1, wobei der Vorläufer eines von Nickelcarbonyl oder Stickstoffwasserstoffsäure ist.

30. System nach Anspruch 1, wobei die Dünnfilmverarbeitungskammer (102, 602a, 602b, 602c, 602d, 602e) eines von einem Batch-Tool, einem eigenständigen Tool oder einem Cluster-Tool ist.

31. Verfahren zur Synthese eines filmbildenden Vorläufers und für den Verbrauch des Vorläufers durch Bildung eines Dünnfilms auf einem Substrat, wobei das Verfahren mit einem System nach einem der vorstehenden Ansprüche ausführbar ist, wobei das Verfahren umfasst:
Bereitstellen einer Rohmaterialquelle (100), welche zumindest ein Rohmaterial enthält;
Zuführen des zumindest einen Rohmaterials aus der Rohmaterialquelle (100) zu einer Vorläufersynthesekammer (101, 201, 301, 404a, 404b, 404c, 504a, 504b, 603a, 603b, 603c, 603d, 603e, 705a, 705b);
Reagieren des zumindest einen Rohmaterials in der Vorläufersynthesekammer (101, 201, 301, 404a, 404b, 404c, 504a, 504b, 603a, 603b, 603c, 603d, 603e, 705a, 705b), um einen Vorläufer zu bilden;
Zuführen des Vorläufers aus der Vorläufersynthesekammer (101, 201, 301, 404a, 404b, 404c, 504a, 504b, 603a, 603b, 603c, 603d, 603e, 705a, 705b) in einer kontrollierten Weise zu einer Dünnfilmverarbeitungskammer (102, 202, 302, 403, 505a, 505b, 602a, 602b, 602c, 602d, 602e, 703a, 703b), wobei die Dünnfilmverarbeitungskammer (102, 202, 302, 403, 505a, 505b, 602a, 602b, 602c, 602d, 602e, 703a, 703b) im Tandem mit der Vorläufersynthesekammer (101, 201, 301, 404a, 404b, 404c, 504a, 504b, 603a, 603b, 603c, 603d, 603e, 705a, 705b) arbeitet und mit dieser verbunden ist,
Anwenden einer Herstellungstechnik für den Verbrauch des Vorläufers, um den Dünnfilm auf einem in der Dünnfilmverarbeitungskammer (102, 202, 302, 403, 505a, 505b, 602a, 602b, 602c, 602d, 602e, 703a, 703b) positionierten Substrat zu bilden;
Durchführen einer Echtzeitüberwachung und -erkennung von zumindest einem Parameter, ausgewählt aus der Gruppe bestehend aus Verarbeitungsparametern der Vorläufersynthesekammer (101, 201, 301, 404a, 404b, 404c, 504a, 504b, 603a, 603b, 603c, 603d, 603e, 705a, 705b), Verarbeitungsparametern der Dünnfilmverarbeitungskammer (102, 202, 302, 403, 505a, 505b, 602a, 602b, 602c, 602d, 602e, 703a, 703b), Parametern von Reaktionsnebenprodukten und Abwässern und zumindest einer Eigenschaft der Dünnfilms; und
Übertragen einer Rückmeldung in Bezug auf den Vorläuferverbrauch und die Dünnfilmbildung an die Vorläufersynthesekammer (101, 201, 301, 404a, 404b, 404c, 504a, 504b, 603a, 603b, 603c, 603d, 603e, 705a, 705b), um die Synthese des Vorläufers so zu steuern, dass (i) die Synthese des Vorläufers gleichzeitig oder parallel zur Dünnfilmbildung erfolgt, (ii) Steuern der Rate der Vorläufersynthese an die Rate des Vorläuferverbrauchs und die Rate der Filmbildung angepasst wird und (iii) Steuern der Rate des Vorläuferverbrauchs und der Rate der Filmbildung an die Rate der Vorläufersynthese angepasst wird.

32. Verfahren nach Anspruch 31, weiter umfassend:
Vergleichen einer Menge oder Konzentration des in die Dünnfilmverarbeitungskammer (102, 202, 302, 403, 505a, 505b, 602a, 602b, 602c, 602d, 602e, 703a, 703b) eintretenden Vorläufers mit einer Menge oder Konzentration des aus der Vorläufersynthesekammer (101, 201, 301, 404a, 404b, 404c, 504a, 504b, 603a, 603b, 603c, 603d, 603e, 705a, 705b) austretenden Vorläufers, um eine Differenz zu berechnen, und Verwenden der Differenz als Teil eines Algorithmus zum Steuern der Rate der Vorläufersynthese in der Vorläufersynthesekammer (101, 201, 301, 404a, 404b). 404c, 504a, 504b, 603a, 603b, 603c, 603d, 603e, 705a, 705b).

33. Verfahren nach Anspruch 31, wobei die Herstellungstechnik eine aus der Gruppe bestehend aus chemischem Dampfniederschlag (CVD), Atomlagenabscheidung (ALD), Flüssigphasenplattierung, Ätzen, Atomlagenätzen, Ionenimplantation und Strukturieren ausgewählt ist.

34. Verfahren nach Anspruch 31, wobei das Zuführen des Vorläufers aus der Vorläufersynthesekammer (101, 201, 301, 404a, 404b, 404c, 504a, 504b, 603a, 603b, 603c, 603d, 603e, 705a, 705b) zur Dünnfilmverarbeitungskammer (102, 202, 302, 403, 505a, 505b, 602a, 602b, 602c, 602d, 602e, 703a, 703b) unter Verwendung von zumindest einem von Vakuum, Inertgas, Wasserstoff, Reaktivgas oder einer Kombination aus Inertgas und Wasserstoff-Reaktivgas durchgeführt wird.

35. Verfahren nach Anspruch 31, wobei der Vorläufer unter Verwendung eines inerten oder reaktiven Trägergases zur Dünnfilmverarbeitungskammer (102, 202, 302, 403, 505a, 505b, 602a, 602b, 602c, 602d, 602e, 703a, 703b) transportiert wird.

36. Verfahren nach Anspruch 31, wobei der Vorläufer verflüchtigt oder verdampft und unter Verwendung seines eigenen Dampfdrucks zur Dünnfilmverarbeitungskammer (102, 202, 302, 403, 505a, 505b, 602a, 602b, 602c, 602d, 602e, 703a, 703b) transportiert wird.

37. Verfahren nach Anspruch 31, wobei:
das Rohmaterial metallisches Nickel ist, das einer Vorläufererzeugungskammer (101, 201, 301, 404a, 404b, 404c, 504a, 504b, 603a, 603b, 603c, 603d, 603e, 705a, 705b) zugeführt wird; und wobei das Verfahren umfasst:
Abdichten der Vorläufererzeugungskammer (101, 201, 301, 404a, 404b, 404c, 504a, 504b, 603a, 603b, 603c, 603d, 603e, 705a, 705b);
Spülen der Vorläufererzeugungskammer (101, 201, 301, 404a, 404b, 404c, 504a, 504b, 603a, 603b, 603c, 603d, 603e, 705a, 705b), um adsorbierte Gase und Restgase zu entfernen;
Erhitzen des metallischen Nickels auf eine Temperatur von 80 °C bis 120 °C;
Zuführen von Kohlenmonoxid zur Vorläufererzeugungskammer (101, 201, 301, 404a, 404b, 404c, 504a, 504b, 603a, 603b, 603c, 603d, 603e, 705a, 705b) und gleichzeitiges Ermöglichen einer Flusskommunikation zwischen dem Vorläufererzeugungssystem (101, 201, 301, 404a, 404b, 404c, 504a, 504b, 603a, 603b, 603c, 603d, 603e, 705a, 705b) und einer nachgeschalteten und verbundenen Dünnfilmverarbeitungskammer (102, 202, 302, 403, 505a, 505b, 602a, 602b, 602c, 602d, 602e, 703a, 703b), um den Nickelcarbonyl-Vorläufer zu erzeugen und den Nickelcarbonyl-Vorläufer direkt aus der Vorläufererzeugungskammer (101, 201, 301, 404a, 404b, 404c, 504a, 504b, 603a, 603b, 603c, 603d, 603e, 705a, 705b) der Dünnfilmverarbeitungskammer (102, 202, 302, 403, 505a, 505b, 602a, 602b, 602c, 602d, 602e, 703a, 703b) zuzuführen;
Erhitzen des Substrats in der Dünnfilmverarbeitungskammer (102, 202, 302, 403, 505a, 505b, 602a, 602b, 602c, 602d, 602e, 703a, 703b) auf eine Temperatur von 180 °C bis 250 °C, sodass sich der Nickelcarbonyl-Vorläufer auf dem Substrat zersetzt und den Nickeldünnfilm bildet;
Durchführen einer Echtzeit-In-situ-Überwachung und -Erkennung der Nickel-Dünnfilmbildung in der Dünnfilmverarbeitungskammer (102, 202, 302, 403, 505a, 505b, 602a, 602b, 602c, 602d, 602e, 703a, 703b); und
Übertragen einer Rückmeldung bezüglich der Nickel-Dünnfilmbildung an die Vorläufererzeugungskammer (101, 201, 301, 404a, 404b, 404c, 504a, 504b, 603a, 603b, 603c, 603d, 603e, 705a, 705b), um eine Erzeugungsrate des Nickel-Carbonyl-Vorläufers so zu steuern, dass die Erzeugung des Nickel-Carbonyl-Vorläufers gleichzeitig oder parallel zur Nickel-Dünnfilmbildung erfolgt.

38. Verfahren nach Anspruch 31, wobei:
das Rohmaterial eine hochsiedende Hydroxylflüssigkeit ist, die im Vergleich zum synthetisierten Vorläufer eine höhere Siedetemperatur aufweist und einer Vorläufererzeugungskammer (101, 201, 301, 404a, 404b, 404c, 504a, 504b, 603a, 603b, 603c, 603d, 603e, 705a, 705b) zugeführt wird, wobei die Vorläufererzeugungskammer (101, 201, 301, 404a, 404b, 404c, 504a, 504b, 603a, 603b, 603c, 603d, 603e, 705a, 705b) einen Gaseinlass in der Nähe eines unteren Endes der Kammer unterhalb des Flüssigkeitsspiegels und einen Gasauslass oberhalb des Flüssigkeitsspiegels aufweist; und wobei das Verfahren umfasst:
Erhitzen der Hydroxylflüssigkeit auf eine Temperatur von 40 °C bis 65 °C, um eine Flüssigkeit zu bilden, die Hydroxylgruppen enthält;
Einführen eines ersten Stroms von in einem Trägergas mitgeführtem Trimethylsilylazid in die Vorläufererzeugungskammer (101, 201, 301, 404a, 404b, 404c, 504a, 504b, 603a, 603b, 603c, 603d, 603e, 705a, 705b) durch den Gaseinlass, wobei das Trimethylsilylazid mit der Hydroxylgruppen enthaltenden Flüssigkeit reagiert und den Stickstoffwasserstoffsäure-Vorläufer erzeugt;
Zuführen eines zweiten Stroms der im Trägergas mitgeführten Stickstoffwasserstoffsäure aus der Vorläufererzeugungskammer (101, 201, 301, 404a, 404b, 404c, 504a, 504b, 603a, 603b, 603c, 603d, 603e, 705a, 705b) direkt zu einer Dünnfilmverarbeitungskammer (102, 202, 302, 403, 505a, 505b, 602a, 602b, 602c, 602d, 602e, 703a, 703b), wobei die Dünnfilmverarbeitungskammer (102, 202, 302, 403, 505a, 505b, 602a, 602b, 602c, 602d, 602e, 703a, 703b) im Tandem mit der Vorläufererzeugungskammer (101, 201, 301, 404a, 404b, 404c, 504a, 504b, 603a, 603b, 603c, 603d, 603e, 705a, 705b) arbeitet und mit dieser verbunden ist;
Erhitzen eines Siliziumsubstrats in der Dünnfilmverarbeitungskammer (102, 202, 302, 403, 505a, 505b, 602a, 602b, 602c, 602d, 602e, 703a, 703b) auf eine Temperatur von 325 °C bis 500 °C, sodass die Stickstoffwasserstoffsäure mit dem Siliziumsubstrat reagiert und den Siliziumnitrid-Dünnfilm bildet;
Durchführen einer Echtzeit-In-situ-Überwachung und -Erkennung der Siliziumnitrid-Dünnfilmbildung in der Dünnfilmverarbeitungskammer (102, 202, 302, 403, 505a, 505b, 602a, 602b, 602c, 602d, 602e, 703a, 703b); und
Übertragen einer Rückmeldung bezüglich der Siliziumnitrid-Dünnfilmbildung an die Vorläufererzeugungskammer (101, 201, 301, 404a, 404b, 404c, 504a, 504b, 603a, 603b, 603c, 603d, 603e, 705a, 705b), um die Erzeugung des Stickstoffwasserstoffsäure-Vorläufers so zu steuern, dass die Erzeugung des Stickstoffwasserstoffsäure-Vorläufers gleichzeitig oder parallel zur Siliziumnitrid-Dünnfilmbildung erfolgt.

## Revendications

1. Système (100) de synthèse d'un précurseur filmogène et de consommation du précurseur par formation d'un film mince sur un substrat, le système (100) comprenant :
une source de matière première (104) contenant au moins une matière première ;
une chambre de synthèse de précurseur (101, 201, 301) incluant une entrée (106) et une sortie (107), l'entrée (107) de la chambre de synthèse de précurseur étant en communication avec la source de matière première (104) pour alimenter la chambre de synthèse de précurseur (101, 201, 301) en matière première où elle réagit pour synthétiser un précurseur ; et
une chambre de traitement de film mince (102, 202) reliée à la chambre de synthèse de précurseur (101, 201, 301), la chambre de traitement de film mince (102, 202) incluant une entrée en communication directe avec et couplée à la sortie de la chambre de synthèse de précurseur (102, 202) d'une manière commandée pour fournir le précurseur de la chambre de synthèse de précurseur (102, 202) à la chambre de traitement de film mince (101, 201, 301) d'une manière commandée pour une consommation du précurseur pour former le film mince sur le substrat dans la chambre de traitement de film mince (102, 202) ;
un système de surveillance (604, 605) pour la surveillance et la détection en temps réel de la formation de film mince dans la chambre de traitement de film mince (102, 202) et de la synthèse de précurseur dans la chambre de synthèse de précurseur (101, 201, 301) ; et
un dispositif de commande (607) pour : (i) recevoir des données du système de surveillance (604) concernant la consommation de précurseur et la formation de film mince et transmettre les données à la chambre de synthèse de précurseur (101, 201, 301) pour commander une vitesse de synthèse de précurseur afin de garantir que la vitesse de synthèse de précurseur corresponde à la vitesse de consommation de précurseur et de formation de film mince, et
(ii) recevoir des données du système de surveillance (605) concernant la synthèse de précurseur et transmettre les données à la chambre de traitement de film mince (102, 202) pour commander des vitesses de consommation de précurseur et de formation de film mince afin de garantir que les vitesses de consommation de précurseur et de formation de film mince correspondent à la vitesse de synthèse de précurseur.

2. Système (100) selon la revendication 1, dans lequel le dispositif de commande (607) est configuré pour comparer une quantité ou une concentration du précurseur entrant dans la chambre de traitement de film mince (102, 202) à une quantité ou une concentration du précurseur sortant de la chambre de synthèse de précurseur (101, 201, 301) pour calculer un différentiel, et pour utiliser le différentiel dans le cadre d'un algorithme pour commander la vitesse de synthèse de précurseur dans la chambre de synthèse de précurseur (101, 201, 301).

3. Système (100) selon la revendication 1, dans lequel le système (100) est un système de boucle de rétroaction comprenant la chambre de synthèse de précurseur (101, 201, 301) et la chambre de traitement de film mince (102, 202) reliée à celle-ci, et dans lequel le système de surveillance et le dispositif de commande (607) commandent et gèrent la communication entre la synthèse de précurseur dans la chambre de synthèse de précurseur (101, 201, 301) et la consommation de précurseur pour former la formation de film mince dans la chambre de traitement de film mince (102, 202).

4. Système (100) selon la revendication 1, dans lequel le dispositif de commande (607) ajuste la vitesse de synthèse de précurseur sur la base de la vitesse de consommation de précurseur.

5. Système (100) selon la revendication 1, dans lequel le système de surveillance comprend au moins une technique parmi des techniques de surveillance et de détection in situ, des techniques de surveillance et de détection ex situ, des spectroscopies et des spectrométries, pour surveiller au moins un paramètre choisi dans le groupe constitué de paramètres de traitement de la chambre de synthèse de précurseur, de paramètres de traitement de la chambre de traitement de film mince, de paramètres de sous-produits de réaction et d'effluents, et de la ou des propriétés du film mince.

6. Système (100) selon la revendication 5, dans lequel le ou les paramètres sont choisis dans le groupe constitué de la température, de la pression, du débit d'une ou plusieurs matières premières du précurseur, du débit du précurseur et de conditions de réaction de synthèse de précurseur.

7. Système (100) selon la revendication 5, dans lequel les techniques de surveillance et de détection in situ et ex situ incluent au moins une technique choisie dans le groupe constitué de l'ellipsométrie, de la spectrométrie de masse, de la spectroscopie infrarouge, de la spectroscopie proche infrarouge, de la spectroscopie optique et de la spectroscopie ultraviolette.

8. Système (100) selon la revendication 1, dans lequel le système de surveillance (604, 605) comprend au moins un capteur intégré in situ et/ou au moins un capteur intégré ex-situ pour la surveillance et la détection en temps réel du ou des paramètre de traitement du système (100) et/ou de la ou des propriétés du film mince.

9. Système (100) selon la revendication 8, dans lequel le ou les capteurs intégrés in situ et/ou le ou les capteurs intégrés ex-situ sont choisis dans le groupe constitué d'un capteur optique, d'un capteur acoustique, d'un capteur électrique, d'un capteur électronique, d'un capteur magnétique, d'un capteur mécanique, d'un capteur électromécanique et d'un capteur électromagnétique.

10. Système (100) selon la revendication 8, dans lequel le ou les paramètres sont choisis dans le groupe constitué de la température, de la pression, du débit de la ou des matières premières du précurseur, du débit du précurseur et de conditions de réaction de synthèse de précurseur.

11. Système (100) selon la revendication 1, dans lequel la chambre de synthèse de précurseur (101, 201, 301) et la chambre de traitement de film mince (102, 202) sont des chambres séparées et distinctes, et dans lequel des environnements intérieurs de la chambre de synthèse de précurseur (101, 201, 301) et de la chambre de traitement de film mince (102, 202) sont isolés l'un de l'autre par un ensemble de vannes.

12. Système (100) selon la revendication 1, dans lequel la chambre de synthèse de précurseur (101, 201, 301) inclut une sortie d'aération pour évacuer des fluides de purge ou des sous-produits de réaction.

13. Système (100) selon la revendication 1, comprenant en outre un système de collecteur (206) reliant la sortie de la chambre de synthèse de précurseur (101, 201) à l'entrée de la chambre de traitement de film mince (102, 202) pour l'écoulement d'un précurseur en phase gazeuse à travers celui-ci.

14. Système (100) selon la revendication 13, comprenant en outre un système de gaz de purge (203) et un système d'aération (205) pour purger et évacuer des conduits du système de collecteur (206).

15. Système (100) selon la revendication 1, comprenant en outre un système de collecteur (306) reliant la sortie de la chambre de synthèse de précurseur (101, 301) à l'entrée de la chambre de traitement de film mince (302) pour l'écoulement d'un précurseur en phase liquide à travers celui-ci.

16. Système selon la revendication 15, comprenant en outre un système de nettoyage (303) configuré pour fournir une solution de solvant à des conduits (307) du système de collecteur (306) pour le nettoyage des conduits, et un système de purge (304) pour éliminer la solution de solvant résiduelle des conduits (307) du système de collecteur (306).

17. Système (100) selon la revendication 1, comprenant une pluralité de chambres de synthèse de précurseur (404a, 404b, 404c) reliées à une seule chambre de traitement de film mince (403).

18. Système (100) selon la revendication 17, dans lequel au moins deux de la pluralité de chambres de synthèse de précurseur (404a, 404b, 404c) sont configurées dans un agencement parallèle, de telle sorte qu'un précurseur soit distribué dans la chambre de traitement de film mince unique (403) simultanément à partir de chaque chambre de synthèse de précurseur (404a, 404b, 404c) dans l'agencement parallèle.

19. Système (100) selon la revendication 18, dans lequel au moins deux de la pluralité de chambres de synthèse de précurseur (404b, 404c) sont configurées dans un agencement en série ou en tandem, de telle sorte qu'un précurseur provenant d'une chambre de synthèse de précurseur en amont (404c) soit distribué dans une chambre de synthèse de précurseur en aval (404b) pour former un mélange de précurseurs, puis le mélange de précurseurs soit distribué dans la chambre de traitement de film mince unique (403) à partir de la chambre de synthèse de précurseur en aval (404b).

20. Système (100) selon la revendication 1, comprenant une pluralité de chambres de synthèse de précurseur (504a, 504b) reliées à une pluralité de chambres de traitement de film mince (505a, 505b).

21. Système (100) selon la revendication 20, comprenant en outre une cassette de stockage (503) pour stocker au moins un substrat, une pluralité de chambres de métrologie (506) pour surveiller au moins une caractéristique du substrat, et un mécanisme de transport (502) pour transporter le substrat entre la cassette de stockage (503), la pluralité de chambres de traitement de film mince (505a, 505b) et la pluralité de chambres de métrologie (506).

22. Système (100) selon la revendication 20, comprenant en outre un outil en grappe intégré à la pluralité de chambres de synthèse de précurseur (603a, 603b, 603c, 603d, 603e) et à la pluralité de chambres de traitement de film mince (602a, 602b, 602c, 602d, 602e).

23. Système (100) selon la revendication 20, dans lequel chaque chambre de synthèse de précurseur (603a, 603b, 603c, 603d, 603e) est reliée à une chambre de traitement de film mince (602a, 602b, 602c, 602d, 602e) correspondante pour distribuer le même précurseur dans la chambre de traitement de film mince (602a, 602b, 602c, 602d, 602e) correspondante sous forme de vapeur ou de liquide.

24. Système (100) selon la revendication 20, dans lequel chaque chambre de synthèse de précurseur (603a, 603b, 603c, 603d, 603e) est reliée à une chambre de traitement de film mince (602a, 602b, 602c, 602d, 602e) correspondante pour distribuer un précurseur différent dans la chambre de traitement de film mince (602a, 602b, 602c, 602d, 602e) correspondante sous forme de vapeur ou de liquide.

25. Système (100) selon la revendication 20, dans lequel le substrat est un substrat flexible sous la forme d'un rouleau continu ou d'une bobine continue, tel qu'un ruban, un rouleau, une bande ou une bobine.

26. Système (100) selon la revendication 25, dans lequel le substrat flexible comprend un rouleau de matière (701) qui est déroulé ou déplié, et qui est introduit de manière commandée dans une ou plusieurs de la pluralité de chambres de traitement de film mince (703a, 703b) qui sont reliées les unes aux autres.

27. Système (100) selon la revendication 26, dans lequel les chambres de traitement de film mince reliées les unes aux autres appliquent la même technique de fabrication au substrat.

28. Système (100) selon la revendication 26, dans lequel chacune des chambres de traitement de film mince reliées les unes aux autres applique une technique de fabrication différente au substrat.

29. Système selon la revendication 1, dans lequel le précurseur est l'un du nickel carbonyle et de l'acide hydrazoïque.

30. Système selon la revendication 1, dans lequel la chambre de traitement de film mince (102, 602a, 602b, 602c, 602d, 602e) est l'un d'un outil par lots, d'un outil autonome et d'un outil en grappe.

31. Procédé de synthèse d'un précurseur filmogène et de consommation du précurseur par formation d'un film mince sur un substrat, dans lequel ledit procédé est exécutable avec un système selon l'une quelconque des revendications précédentes, le procédé comprenant :
la fourniture d'une source de matière première (100) contenant au moins une matière première ;
la fourniture de la ou des matières premières provenant de la source de matière première (100) à une chambre de synthèse de précurseur (101, 201, 301, 404a, 404b, 404c, 504a, 504b, 603a, 603b, 603c, 603d, 603e, 705a, 705b) ;
la réaction de la ou des matières premières dans la chambre de synthèse de précurseur (101, 201, 301, 404a, 404b, 404c, 504a, 504b, 603a, 603b, 603c, 603d, 603e, 705a, 705b) pour former un précurseur ;
l'alimentation de manière commandée d'une chambre de traitement de film mince (102, 202, 302, 403, 505a, 505b, 602a, 602b, 602c, 602d, 602e, 703a, 703b) en précurseur provenant de la chambre de synthèse de précurseur (101, 201, 301, 404a, 404b, 404c, 504a, 504b, 603a, 603b, 603c, 603d, 603e, 705a, 705b), la chambre de traitement de film mince (102, 202, 302, 403, 505a, 505b, 602a, 602b, 602c, 602d, 602e, 703a, 703b) fonctionnant en tandem avec et étant reliée à la chambre de synthèse de précurseur (101, 201, 301, 404a, 404b, 404c, 504a, 504b, 603a, 603b, 603c, 603d, 603e, 705a, 705b),
l'application d'une technique de fabrication pour une consommation du précurseur pour former le film mince sur un substrat positionné dans la chambre de traitement de film mince (102, 202, 302, 403, 505a, 505b, 602a, 602b, 602c, 602d, 602e, 703a, 703b) ;
la réalisation d'une surveillance et d'une détection en temps réel d'au moins un paramètre choisi dans le groupe constitué de paramètres de traitement de la chambre de synthèse de précurseur (101, 201, 301, 404a, 404b, 404c, 504a, 504b, 603a, 603b, 603c, 603d, 603e, 705a, 705b), de paramètres de traitement de la chambre de traitement de film mince (102, 202, 302, 403, 505a, 505b, 602a, 602b, 602c, 602d, 602e, 703a, 703b), de paramètres de sous-produits et d'effluents de réaction, et d'au moins une propriété de la couche mince ; et
la transmission d'une rétroaction concernant la consommation de précurseur et la formation de film mince à la chambre de synthèse de précurseur (101, 201, 301, 404a, 404b, 404c, 504a, 504b, 603a, 603b, 603c, 603d, 603e, 705a, 705b) pour commander la synthèse du précurseur, de telle sorte que (i) la synthèse du précurseur se produise simultanément ou en tandem avec la formation de film mince, (ii) la commande de la vitesse de synthèse de précurseur corresponde à la vitesse de consommation de précurseur et à la vitesse de formation de film, et (iii) la commande de la vitesse de consommation de précurseur et de la vitesse de formation de film corresponde à la vitesse de synthèse de précurseur.

32. Procédé selon la revendication 31, comprenant en outre
la comparaison de la quantité ou la concentration du précurseur entrant dans la chambre de traitement de film mince (102, 202, 302, 403, 505a, 505b, 602a, 602b, 602c, 602d, 602e, 703a, 703b) à la quantité ou la concentration du précurseur sortant de la chambre de synthèse de précurseur (101, 201, 301, 404a, 404b, 404c, 504a, 504b, 603a, 603b, 603c, 603d, 603e, 705a, 705b) pour calculer un différentiel, et l'utilisation de ce différentiel dans le cadre d'un algorithme pour commander la vitesse de synthèse de précurseur dans la chambre de synthèse de précurseur (101, 201, 301, 404a), 404b, 404c, 504a, 504b, 603a, 603b, 603c, 603d, 603e, 705a, 705b).

33. Procédé selon la revendication 31, dans lequel la technique de fabrication est choisie dans le groupe constitué du dépôt chimique en phase vapeur (CVD), du dépôt de couche atomique (ALD), du placage en phase liquide, de la gravure, de la gravure de couche atomique, de l'implantation ionique et de la formation de motifs.

34. Procédé selon la revendication 31, dans lequel l'alimentation de la chambre de traitement de film mince (102, 202, 302, 403, 505a, 505b, 602a, 602b, 602c, 602d, 602e, 703a, 703b) en précurseur provenant de la chambre de synthèse de précurseur (101, 201, 301, 404a, 404b, 404c, 504a, 504b, 603a, 603b, 603c, 603d, 603e, 705a, 705b) est réalisée en utilisant au moins un du vide, d'un gaz inerte, de l'hydrogène, d'un gaz réactif ou d'une combinaison de gaz inerte et de gaz réactif à l'hydrogène.

35. Procédé selon la revendication 31, dans lequel le précurseur est transporté vers la chambre de traitement de film mince (102, 202, 302, 403, 505a, 505b, 602a, 602b, 602c, 602d, 602e, 703a, 703b) à l'aide d'un gaz vecteur inerte ou réactif.

36. Procédé selon la revendication 31, dans lequel le précurseur est volatilisé ou évaporé et transporté vers la chambre de traitement de film mince (102, 202, 302, 403, 505a, 505b, 602a, 602b, 602c, 602d, 602e, 703a, 703b) à l'aide de sa propre pression de vapeur.

37. Procédé selon la revendication 31, dans lequel :
la matière première est du nickel métallique qui est introduit dans une chambre de génération de précurseur (101, 201, 301, 404a, 404b, 404c, 504a, 504b, 603a, 603b, 603c, 603d, 603e, 705a, 705b) ; et dans lequel le procédé comprend :
le scellement de la chambre de génération de précurseur (101, 201, 301, 404a, 404b, 404c, 504a, 504b, 603a, 603b, 603c, 603d, 603e, 705a, 705b) ;
la purge de la chambre de génération de précurseur (101, 201, 301, 404a, 404b, 404c, 504a, 504b, 603a, 603b, 603c, 603d, 603e, 705a, 705b) pour évacuer des gaz adsorbés et résiduels ;
le chauffage du nickel métallique en vrac à une température de 80 °C à 120 °C ;
l'alimentation de la chambre de génération de précurseur (101, 201, 301, 404a, 404b, 404c, 504a, 504b, 603a, 603b, 603c, 603d, 603e, 705a, 705b) en monoxyde de carbone et l'activation simultanée d'une communication de flux entre le système de génération de précurseur (101, 201, 301, 404a, 404b, 404c, 504a, 504b, 603a, 603b, 603c, 603d, 603e, 705a, 705b) et une chambre de traitement de film mince (102, 202, 302, 403, 505a, 505b, 602a, 602b, 602c, 602d, 602e, 703a, 703b) en aval de celui-ci et reliée à celui-ci, de manière à générer le précurseur de nickel carbonyle et à fournir le précurseur de nickel carbonyle directement depuis la chambre de génération de précurseur (101, 201, 301, 404a, 404b, 404c, 504a, 504b, 603a, 603b, 603c, 603d, 603e, 705a, 705b) à la chambre de traitement de film mince (102, 202, 302, 403, 505a, 505b, 602a, 602b, 602c, 602d, 602e, 703a, 703b) ;
le chauffage du substrat dans la chambre de traitement de film mince (102, 202, 302, 403, 505a, 505b, 602a, 602b, 602c, 602d, 602e, 703a, 703b) à une température de 180 °C à 250 °C, de telle sorte que le précurseur de nickel carbonyle se décompose sur le substrat pour former le film mince de nickel ;
la réalisation d'une surveillance et d'une détection in situ en temps réel de la formation de film mince de nickel dans la chambre de traitement des film mince (102, 202, 302, 403, 505a, 505b, 602a, 602b, 602c, 602d, 602e, 703a, 703b) ; et
la transmission d'une rétroaction concernant la formation de film mince de nickel à la chambre de génération de précurseur (101, 201, 301, 404a, 404b, 404c, 504a, 504b, 603a, 603b, 603c, 603d, 603e, 705a, 705b) pour commander une vitesse de génération du précurseur de nickel carbonyle, de telle sorte qu'une génération du précurseur de nickel carbonyle se produise simultanément ou en tandem avec la formation de film mince de nickel.

38. Procédé selon la revendication 31, dans lequel :
la matière première est un liquide hydroxylique à point d'ébullition élevé, qui présente une température d'ébullition plus élevée que celle du précurseur synthétisé et est fourni à une chambre de génération de précurseur (101, 201, 301, 404a, 404b, 404c, 504a, 504b, 603a, 603b, 603c, 603d, 603e, 705a, 705b), la chambre de génération de précurseur (101, 201, 301, 404a, 404b, 404c, 504a, 504b, 603a, 603b, 603c, 603d, 603e, 705a, 705b) présentant une entrée de gaz à proximité d'une extrémité inférieure de la chambre en dessous du niveau de liquide et une sortie de gaz au-dessus du niveau de liquide ; et dans lequel le procédé comprend :
le chauffage du liquide hydroxylique à une température de 40 °C à 65 °C pour former un liquide contenant des groupes hydroxyles ;
l'introduction d'un premier flux de triméthylsilylazide entraîné dans un gaz vecteur dans la chambre de génération de précurseur (101, 201, 301, 404a, 404b, 404c, 504a, 504b, 603a, 603b, 603c, 603d, 603e, 705a, 705b) à travers l'entrée de gaz, dans lequel le triméthylsilylazide réagit avec le liquide contenant des groupes hydroxyles et génère le précurseur d'acide hydrazoïque ;
la fourniture d'un second flux d'acide hydrazoïque entraîné dans le gaz vecteur depuis la chambre de génération de précurseur (101, 201, 301, 404a, 404b, 404c, 504a, 504b, 603a, 603b, 603c, 603d, 603e, 705a, 705b) directement vers une chambre de traitement de film mince (102, 202, 302, 403, 505a, 505b, 602a, 602b, 602c, 602d, 602e, 703a, 703b), la chambre de traitement de film mince (102, 202, 302, 403, 505a, 505b, 602a, 602b, 602c, 602d, 602e, 703a, 703b) fonctionnant en tandem avec et étant reliée à la chambre de génération de précurseur (101, 201, 301, 404a, 404b, 404c, 504a, 504b, 603a, 603b, 603c, 603d, 603e, 705a, 705b) ;
le chauffage d'un substrat de silicium dans la chambre de traitement de film mince (102, 202, 302, 403, 505a, 505b, 602a, 602b, 602c, 602d, 602e, 703a, 703b) à une température de 325 °C à 500 °C, de telle sorte que l'acide hydrazoïque réagisse avec le substrat de silicium pour former le film mince de nitrure de silicium ;
la réalisation d'une surveillance et d'une détection in situ en temps réel de la formation de film mince de nitrure de silicium dans la chambre de traitement de film mince (102, 202, 302, 403, 505a, 505b, 602a, 602b, 602c, 602d, 602e, 703a, 703b) ; et
la transmission d'une rétroaction concernant la formation de film mince de nitrure de silicium à la chambre de génération de précurseur (101, 201, 301, 404a, 404b, 404c, 504a, 504b, 603a, 603b, 603c, 603d, 603e, 705a, 705b) pour commander la génération du précurseur d'acide hydrazoïque, de telle sorte que la génération du précurseur d'acide hydrazoïque se produise simultanément ou en tandem avec la formation de film mince de nitrure de silicium.
